Europäisches Patentamt

European Patent Office

Office européen des brevets

(19)

(11) **EP 1 129 407 B1**

(12) **FASCICULE DE BREVET EUROPEEN**

(45) Date de publication et mention
de la délivrance du brevet:
**18.12.2002 Bulletin 2002/51**

(51) Int Cl.⁷: **G06F 11/24**, G01R 31/30,
G01R 31/3173

(21) Numéro de dépôt: **99920908.3**

(22) Date de dépôt: **21.05.1999**

(86) Numéro de dépôt international:
**PCT/FR99/01212**

(87) Numéro de publication internationale:
**WO 00/029953 (25.05.2000 Gazette 2000/21)**

(54) **PROCEDE ET INSTALLATION DE LOCALISATION RAPIDE D'UN DEFAUT DANS UN CIRCUIT INTEGRE**

VERFAHREN UND VORRICHTUNG ZUR SCHNELLEN FEHLERERKENNUNG IN EINER INTEGRIERTEN SCHALTUNG

METHOD AND INSTALLATION FOR FAST FAULT LOCALIZATION IN AN INTEGRATED CIRCUIT

(84) Etats contractants désignés:
**DE FR GB IE IT**

(30) Priorité: **13.11.1998 FR 9814277**

(43) Date de publication de la demande:
**05.09.2001 Bulletin 2001/36**

(73) Titulaire: **CENTRE NATIONAL D'ETUDES SPATIALES**
**F-75039 Paris Cedex 01 (FR)**

(72) Inventeurs:
• **DESPLATS, Romain**
**F-31400 Toulouse (FR)**
• **PERDU, Philippe**
**F-31100 Toulouse (FR)**

(74) Mandataire:
**Cabinet BARRE LAFORGUE & associés**
**95, rue des Amidonniers**
**31000 Toulouse (FR)**

(56) Documents cités:
**EP-A- 0 785 513          US-A- 5 321 354**

**Description**

L'invention concerne un procédé et une installation de localisation rapide d'un défaut dans un circuit intégré tel qu'un circuit intégré logique.

Malgré les progrès réalisés pour la conception et la fabrication des circuits intégrés, de nombreux défauts affectent le rendement de fabrication ou la fiabilité des circuits fabriqués. Il s'agit principalement de défauts de fabrication ou de défauts de conception. Ainsi, une grande proportion (de l'ordre de 15%) des circuits issus des premières séries de fabrication par fonderie (dépôts successifs à l'aide de masques) n'est pas fonctionnelle et présente des défauts. Cette proportion augmente avec la complexité et le haut degré d'intégration des circuits intégrés, dits LSI ou VLSI, et leur miniaturisation. La mise au point de la fabrication industrielle d'un circuit intégré nécessite donc d'effectuer au préalable quelques lots prototypes que l'on teste pour vérifier leurs caractéristiques électriques réelles. Certains défauts peuvent être révélés par ces tests, ou ultérieurement au cours de l'utilisation des circuits intégrés tout au long de leur existence.

Il en va ainsi tant pour les circuits intégrés commerciaux fabriqués en grandes séries que pour les circuits intégrés spécifiques (ASIC).

Lorsqu'un circuit intégré testé s'avère être défaillant, il est alors important de pouvoir localiser, dans une deuxième étape, très précisément, au sein de la puce du circuit intégré, le défaut qui est à l'origine de la défaillance fonctionnelle. En effet, cette localisation permet de déterminer la cause réelle de la défaillance et donc d'apporter les mesures correctrices appropriées.

Ainsi, la localisation des défauts dans les circuits intégrés doit pouvoir être effectuée depuis la conception (déboggage), la fabrication (pour la validation), le contrôle qualité (pour la production), jusqu'à l'analyse des défaillances de circuits intégrés finis par l'utilisateur final.

Les opérations nécessaires à la localisation des défauts doivent être effectuées aussi rapidement que possible. On sait en effet que les délais de conception et de fabrication des circuits intégrés représentent l'un des enjeux stratégiques les plus importants dans le développement des industries de haute technologie, et ce aussi bien pour les fabriquants de circuits intégrés que pour leurs clients, tels que l'industrie spatiale.

Ainsi, la réussite d'un projet spatial tel qu'un lancement de satellite est, compte tenu de la concurrence exercée dans ce domaine, étroitement liée aux performances, au coût, à la fiabilité et à la qualité des composants utilisés, dont les circuits intégrés logiques, qui en déterminent l'intérêt technique et économique et la faisabilité.

Les circuits intégrés à haut degré d'intégration (LSI ou VLSI) peuvent être réalisés selon différentes technologies : circuits MOS (dont les circuits CMOS utilisés dans les systèmes spatiaux compte tenu de leur très faible consommation électrique) ; circuits bipolaires ; circuits BICMOS ; ...).

Ces circuits sont de plus en plus complexes et présentent une densité d'intégration toujours croissante (qui double quasiment tous les dix-huit mois selon la loi établie par Gordon Moore). Les circuits intégrés peuvent ainsi aujourd'hui incorporer plusieurs centaines de bornes et plusieurs millions de portes logiques formées de transistors. Dès lors, la localisation des défauts est de plus en plus difficile et longue.

De très nombreuses techniques ont été développées pour la localisation des défauts.

Lors de la fabrication, on a accès aux bases de données de conception (CAO) et aux systèmes de simulation. Différents procédés de localisation ont donc été proposés, basés sur une comparaison avec un dictionnaire de fautes ou des données de simulation.

Mais ces données n'étant pas disponibles en toutes circonstances, on a proposé des méthodes basées sur la comparaison d'images par rapport à un circuit de référence exempt de défaut, désigné dans tout le texte par "circuit étalon". Pour acquérir ces images, plusieurs technologies ont été envisagées.

La microscopie optique présente une résolution qui ne peut être meilleure que $1\mu$, et n'est plus compatible avec la surface, le nombre de niveaux d'interconnexions, et les plans de distribution de puissance des puces des circuits modernes. En outre, les défauts sont localisés par inspection visuelle.

De nombreuses techniques font appel à l'imagerie par microscopie électronique à balayage. Les méthodes utilisant des cristaux liquides permettent de visualiser les points chauds et les trous dans les oxydes. Les défauts émissifs (perçage d'oxyde de grille, jonctions pn dégradées ; transistors MOS en saturation...) peuvent être localisés par microscopie à émission de lumière. D'autres méthodes permettent de comparer les potentiels en différents points du circuit : test sous micro-pointes, dispositifs électro-optiques, mesure induite de potentiel par laser, microscopie par sonde à balayage, imagerie microthermographique fluorescente....

Ces méthodes sont pour la plupart lourdes et longues à mettre en oeuvre. Plusieurs d'entre elles sont encore réservées à un usage de laboratoire et ne sont pas encore accessibles à l'échelle industrielle.

Il a aussi déjà été proposé dès 1984 ("Dynamic Fault imaging of VLSI random logic devices" T.C. MAY et al, IEEE, international reliability physics symposium, pp 95-108, 1984), de localiser les défauts de type court-circuit à partir d'images microscopiques par contraste de potentiel.

La première méthode proposée, dite dynamique ou DFI ("dynamic fault imaging"), consistait à comparer les images du circuit défaillant et du circuit de référence en mode stroboscopique. La stratégie de recherche, dite "backtracing", consistait à rechercher la porte défaillante en remontant dans le temps la séquence de vecteurs de test à partir de la manifestation fonctionnelle du défaut sur une borne de sortie du circuit. Cette méthode est limitée par le temps d'acquisition, de l'ordre de 20 min, de chaque image.

On a proposé d'acquérir ces images en temps réel pour réduire cette durée d'acquisition à quelques secondes ("E-beam static fault imaging with a CAD interface and its application to marginal fault diagnosis" N. KUJI et al, IEICE Transactions on Electronics v E77-C, n° 4, pp 552-559, 1994). Le problème de cette méthode, dite statique ou SFI ("static fault imaging"), est qu'elle nécessite de disposer du dessin des masques de la base de données de conception ("layout"), ce qui n'est pas toujours possible. En outre, une dépassivation des circuits doit être effectuée pour pallier au problème de l'effet de décharge faisant disparaître le contraste.

Des optimisations de ces méthodes DFI ou SFI ont été proposées : méthode dite TSFI : "Efficient dynamic fault imaging by fully utilising CAD data in CAD-linked electron beam test systems", K. NAKAMAE et al., IEICE Transactions on Electronics, v E77-C, n° 4, pp 546, 551, 1994 ; méthode dite CGFI : "LSI fast fault localisation by continuously gated fault imaging method", T.T. NAKAMURA et al, NEC Research & Development, v 35, n° 3, pp 269-277, 1994.

US-5703492 décrit aussi une méthode dans laquelle on cherche à pallier au problème du grand nombre d'images à réaliser et à enregistrer en ne mémorisant pas les images, mais en affichant en temps réel alternativement ou simultanément une image d'une zone de la surface entière de la puce du circuit défaillant et du circuit étalon non défaillant, de sorte que ces images sont superposées et comparées en temps réel par examen visuel par un opérateur humain, sans être mémorisées.

Les publications "Failure analysis by dynamic voltage contrast development of a semi-automatic system" N. GERAUD-LINIA et al, ISTFA 1987, Los Angeles, pp 67-73 ; "Etude de circuits intégrés par contraste de potentiel : analyse des phénomènes de charge induits dans la couche de passivation" Thèse de doctorat de l'UNIVERSITE PAUL SABATIER de Philippe PERDU n° 1740, pp 37-50, 1994 décrivent une méthode semi-automatique consistant à observer le circuit défaillant et un circuit étalon en mode statique et en mode dynamique à partir d'une séquence de vecteurs de test choisie pour que le circuit défaillant manifeste un défaut en sortie après l'application du dernier vecteur de test. En pratique, cette séquence correspond à celle qui a permis la détection du défaut lors d'une étape de test préalable.

Comme l'indique ce dernier document, la localisation du défaut dans le cas des circuits logiques séquentiels pose problème et est très longue et difficile. Il en est de même pour tous les circuits qui ne sont pas uniquement en logique combinatoire. En effet, il est nécessaire d'enregistrer des jeux d'images pour chaque vecteur de la séquence de vecteurs de test appliqué aux bornes d'entrée du circuit, et ce aussi bien pour le circuit défaillant que pour le circuit étalon. On doit ensuite réaliser une comparaison par superposition entre des images qui n'ont pas été réalisées avec le même circuit, ni dans les mêmes conditions expérimentales.

Comme l'indique ce dernier document, le traitement des images nécessite toujours une intervention humaine pour choisir, selon la qualité et la nature de chaque image, les traitements qui lui seront appliqués, et pour effectuer la localisation par inspection visuelle des images superposées.

Une méthode d'exécution semi-automatique, dit IFA "Image fault analysis") a aussi été développée pour la mise en oeuvre de la méthode CGFI sur les systèmes de test par faisceau d'électrons, dits IDS, commercialisés par la société SCHLUMBERGER TECHNOLOGIES (FRANCE). La méthode IFA peut être "automatique" (on acquiert l'intégralité des images des vecteurs) ou être combinée avec une recherche récurrente ("backtracing") ou par dichotomie.

Toutes ces méthodes posent deux problèmes principaux qui en limitent les performances et les applications pratiques : elles sont trop longues et/ou sont impossibles en pratique à mettre en oeuvre compte tenu des défauts d'alignement des circuits.

Ainsi, avec ces méthodes, on est obligé de traiter puis de superposer, pour de nombreux vecteurs, toutes les images du circuit défaillant et du circuit étalon, ce qui est extrêmement long. Par exemple, avec une puce de 100 mm$^2$ en technologie de 1$\mu$, un nombre de cases de grilles de 100 et 1000 vecteurs, la méthode IFA nécessite 1.000.000 images en automatique, 600 images avec une recherche récurrente et 100 images avec une recherche par dichotomie simple.

En outre, lorsque l'apparition du défaut est détectée par examen de la fonctionnalité électrique des bornes de sortie selon les signaux d'entrée (recherche récurrente), il est nécessaire d'examiner et de comparer respectivement les images des vecteurs antérieurs de la séquence pour arriver aux images dans lesquelles la porte logique défaillante du circuit à l'origine du défaut fonctionnel en sortie est visualisée. Outre le fait que cet examen rétrospectif est long, on n'est jamais sûr que les images examinées sont bien celles qui permettent de visualiser la porte logique défaillante qui est à l'origine du défaut fonctionnel.

Ainsi, les informations obtenues dans ces méthodes antérieures doivent quasiment toujours être combinées avec des informations issues de méthodes de simulation logicielle cherchant à recréer le défaut par hypothèses successives et/ou avec les dessins de conception du circuit "layout").

Dès lors, la localisation d'un défaut dans ces conditions nécessite en pratique une durée très importante qui est, pour chaque circuit, d'un ou plusieurs jours, et peut aller jusqu'à plusieurs semaines pour les circuits intégrés les plus complexes.

Par ailleurs, certaines au moins de ces méthodes antérieures, notamment celles consistant à acquérir et à comparer directement les images en temps réel sans aucun traitement (US-5703492), sont impossibles à mettre en oeuvre en pratique. En effet, la comparaison d'images de deux circuits distincts suppose qu'il soit possible d'aligner parfaitement les deux circuits comparés, et fait ainsi abstraction des conditions réelles d'observation des deux circuits qui ne peuvent pas être en pratique identiques. Une simple différence d'épaisseur de colle entre les deux puces, ou des différences de déformation des deux circuits lors de l'acquisition des images, suffit à empêcher toute comparaison pertinente des images.

De surcroît, les méthodes antérieures ne permettent pas la localisation de défauts légers qui ne se manifestent pas par un défaut de fonctionnalité électronique sur les bornes de sortie. Or, une bonne proportion des défaillances différées des circuits au cours de leur utilisation provient de tels défauts légers.

Un circuit intégré comprend une puce, des bornes d'entrée et des bornes de sortie reliées les unes aux autres par des pistes électriquement conductrices, et des portes logiques formées au sein de la puce du circuit intégré en forme générale de plaquette définissant un plan principal de la puce, les pistes s'étendant dans l'épaisseur de la puce ou en surface, globalement parallèlement au plan principal, les bornes d'entrée et de sortie étant reliées aux pistes à la périphérie de la puce, et au moins deux bornes d'alimentation en énergie électrique sous tension continue (VDD-VSS), dont au moins une borne d'alimentation reliée à un potentiel haut VDD et au moins une borne d'alimentation reliée à un potentiel bas VSS.

Dans tout le texte, on désigne par "défaut de type court-circuit", tout défaut de la puce créant ou pouvant créer ultérieurement une surconsommation de courant électrique d'alimentation du circuit. Il peut s'agir d'un collage ou pseudo-collage d'une porte logique, d'une fuite de courant dans une porte logique, d'un pontage entre pistes... Selon les fabricants de circuits intégrés, on sait que plus de 80% des défauts des circuits intégrés sont des défauts de type court-circuit de la puce. Cette expression n'englobe pas les défauts extérieurs à la puce elle-même, ou ceux n'influençant que les courants des bornes d'entrée et/ou sortie du circuit.

Par "ligne équipotentielle d'entrée" d'une porte logique on désigne tout le réseau de pistes conductrices ayant le même potentiel électrique s'étendant entre cette porte logique et une ou plusieurs borne(s) d'entrée ; ou entre cette porte logique, et, s'il en existe, au moins une autre porte logique de laquelle(lesquelles) elle reçoit le(les) signal(aux) en provenance d'une(des) borne(s) d'entrée. De même, par "ligne équipotentielle de sortie" d'une porte logique, on désigne tout le réseau de pistes conductrices ayant le même potentiel électrique s'étendant entre cette porte logique et une ou plusieurs borne(s) de sortie ; ou entre cette porte logique et, s'il en existe, au moins une autre porte logique à laquelle (auxquelles) elle délivre un signal destiné à une(des) borne(s) de sortie.

L'invention vise donc à pallier les inconvénients susmentionnés, et à proposer un procédé permettant de localiser un défaut de type court-circuit d'une porte logique défaillante d'un circuit intégré défaillant qui soit beaucoup plus rapide que par le passé, et notamment qui puisse être effectué en une durée très inférieure à une journée, y compris pour les circuits intégrés complexes, cette durée étant en général inférieure à 1h.

L'invention vise aussi à permettre de localiser un défaut par comparaison d'images d'au moins un circuit, c'est-à-dire du circuit défaillant et/ou d'un circuit étalon.

L'invention vise en particulier à limiter considérablement le nombre de comparaisons d'images à réaliser pour isoler la porte logique défaillante.

L'invention vise aussi à automatiser le plus possible cette comparaison d'images, et le procédé de localisation, en réduisant au minimum l'intervention humaine. L'invention vise en particulier à permettre une analyse d'images pour la localisation de la porte logique défaillante qui puisse être exécutée systématiquement à l'aide d'un système informatique.

L'invention vise aussi à permettre de former une image représentant uniquement la porte logique défaillante et/ou la ligne équipotentielle d'entrée et/ou la ligne équipotentielle de sortie de la porte logique défaillante.

L'invention vise à permettre la localisation rapide d'une porte logique défaillante par imagerie même dans le cas des circuits séquentiels, en permettant la réalisation rapide d'au moins une image représentant la porte logique défaillante à l'état défaillant.

L'invention vise à permettre la localisation d'un défaut, y compris lorsque le circuit défaillant présente les mêmes fonctionnalités électroniques qu'un circuit étalon, c'est-à-dire lorsque le défaut ne peut pas être détecté sur les bornes de sortie du circuit défaillant.

L'invention vise en particulier à permettre la localisation de portes logiques défaillantes qui ne nuisent pas à la fonctionnalité électronique du circuit, les signaux reçus aux bornes de sortie étant considérés comme corrects.

L'invention vise aussi à permettre la localisation d'un défaut d'un circuit intégré défaillant ayant préalablement subi une étape de test ayant abouti à la mise en évidence de la défaillance du circuit.

L'invention vise en outre à proposer une installation de mise en oeuvre du procédé selon l'invention.

L'invention telle que definie par les revendications indépendantes concerne ainsi un procédé de localisation d'un défaut de type court-circuit d'une porte logique, dite porte logique défaillante, d'un circuit intégré, dit circuit intégré défaillant, dans lequel :

- on crée et on enregistre une séquence de vecteurs distincts, dits vecteurs de localisation, formés chacun d'un ensemble de signaux adaptés pour pouvoir être appliqués aux différentes bornes d'entrée du circuit défaillant,

- pour au moins un vecteur de localisation appliqué aux bornes d'entrée du circuit défaillant et/ou d'un circuit intégré, dit circuit étalon, qui est exempt de porte défaillante et de tout défaut, et est identique par ailleurs au circuit défaillant, on réalise et on enregistre un jeu d'images, dites images de vecteur, représentant des lignes équipotentielles formées par les pistes et les portes logiques dudit circuit, chaque ligne équipotentielle correspondant à l'un des états de potentiel différenciés sur les images de vecteur, les différentes images de vecteur d'un même jeu d'images étant adaptées pour couvrir et représenter toute la surface de la puce ou toute une portion de cette surface sur laquelle on cherche à localiser la porte logique défaillante,

caractérisé en ce que :

- chaque vecteur de localisation est formé de signaux binaires prenant l'un des états logiques 0 et 1 et conservant cet état logique pendant toute une durée pendant laquelle on considère que le vecteur de localisation est appliqué aux bornes d'entrée, de sorte que cette séquence peut être appliquée pas à pas, un vecteur de localisation après l'autre, et en maintenant chaque vecteur de localisation appliqué pendant une durée aussi longue que nécessaire sur les bornes d'entrée du circuit défaillant et/ou d'un circuit étalon sans que l'état électrique de ce circuit ne change pendant cette durée,
- on applique pas à pas la séquence de vecteurs de localisation aux bornes d'entrée du circuit défaillant, et pour chaque vecteur de localisation, on mesure la valeur IDDQ(j) du courant de consommation électrique au repos IDDQ du circuit défaillant circulant dans l'une au moins des bornes d'alimentation, et on détermine si cette valeur mesurée IDDQ(j) est normale ou anormale et on enregistre le résultat de cette détermination,
- on applique au moins un vecteur de localisation, dit vecteur de localisation anormal, aux bornes d'entrée du circuit défaillant et/ou d'un circuit étalon, pour lequel on a préalablement déterminé et enregistré le fait que la valeur mesurée IDDQ(j) du courant de consommation électrique au repos IDDQ du circuit défaillant est anormale, et on réalise et on enregistre un jeu d'images, dites images de vecteur anormal, dudit circuit avec ce vecteur de localisation anormal,
- dans une étape ultérieure de localisation de la porte défaillante, on effectue au moins une comparaison entre au moins une image de vecteur anormal et une autre image préenregistrée, dite image de référence, correspondant à une même portion de surface de la puce du circuit défaillant ou du circuit étalon que l'image de vecteur anormal, ces images étant choisies pour que cette comparaison permette de sélectionner une zone, dite zone de défaillance, de la surface de la puce sur laquelle peut être située une ligne équipotentielle d'entrée de la porte logique défaillante et/ou une ligne équipotentielle de sortie de la porte logique défaillante et/ou la porte logique défaillante.

Dans l'invention, la séquence de vecteurs utilisée est une séquence spécifique plus complexe que dans l'art antérieur. En effet, cette séquence formée de vecteurs de signaux au format dit NRZ (sans retour à l'état initial pendant l'application d'une commande) comprend un plus grand nombre de vecteurs que les séquences de vecteurs de test qui sont classiquement au format RTZ ou RTO (retour à zéro). Malgré cela, les inventeurs ont déterminé que cette séquence plus complexe nécessitant un traitement préalable, loin de ralentir la localisation du défaut, permet au contraire d'en améliorer les performances en vitesse et en fiabilité. En effet, cette séquence peut être ensuite appliquée en mode pas à pas et permet d'identifier avec certitude la première modification d'état logique du circuit (c'est-à-dire le premier vecteur) excitant la porte défaillante, avec la simple mesure du courant IDDQ, et de réaliser ensuite les images de vecteur correspondant exactement à cette excitation de la porte défaillante, sans erreur possible, y compris dans le cas d'un circuit logique séquentiel et d'un défaut léger non fonctionnel.

Il est à noter que dans le cadre des simples tests de défaillance effectués préalablement à toute analyse ou localisation de défauts, une méthode de test connue consiste à mesurer le courant électrique de consommation au repos IDDQ du circuit intégré alors qu'on applique des vecteurs de tests aux bornes d'entrée du circuit selon une séquence que l'on déroule en continu. Si la valeur mesurée dépasse une valeur seuil prédéterminée, le circuit est considéré comme défaillant. Il est considéré comme nominal dans le cas contraire. La séquence de vecteurs de test est déterminée pour être aussi rapide que possible (nombre de vecteurs minimum) tout en offrant une couverture de test du courant IDDQ optimale (tous les cas de fonctions électroniques étant examinés). Avec ces méthodes de test, on ne peut pas enregistrer des mesures de courant IDDQ à chaque vecteur de test et on ne réalise pas d'imagerie. En outre, chaque vecteur de test est au format des voies des bornes d'entrée (RTZ, RTO...) et les valeurs des signaux d'entrée peuvent varier au cours du même vecteur de test. En conséquence, les solutions adaptées pour de telles méthodes des tests n'étaient pas a priori applicables pour la localisation de défaut. Il en va ainsi d'autant plus pour la localisation de défaut par imagerie en contraste de potentiel dans laquelle on détecte des potentiels électriques et non des courants électriques.

Par contre, dans l'invention, la séquence de vecteurs de localisation est adaptée pour être exécutée pas à pas, et pour permettre une mesure du courant de consommation IDDQ sans changement de l'état électrique du circuit au cours de cette mesure. De la sorte, la valeur du courant IDDQ n'a pas pour fonction de détecter l'existence d'un défaut, mais de reproduire, avec la séquence de vecteurs de localisation, le premier et chaque changement électrique produisant le défaut, et d'enregistrer chaque vecteur de localisation anormal correspondant. Il est ensuite possible d'acquérir et d'enregistrer les images correspondant à un tel vecteur de localisation anormal, ce qui accélère considérablement la localisation de la porte défaillante.

Avantageusement et selon l'invention, on exécute les étapes suivantes chronologiquement :

- dans une première étape, on crée et on enregistre la séquence de vecteurs de localisation,
- dans une deuxième étape, on applique pas à pas la séquence de vecteurs de localisation aux bornes d'entrée du circuit défaillant, on mesure la valeur IDDQ(j) du courant de consommation électrique au repos IDDQ du circuit défaillant pour chaque vecteur de localisation, on détermine si le vecteur de localisation est anormal, et on enregistre cette information,
- dans une troisième étape, on sélectionne et on enregistre parmi la séquence de vecteurs de localisation, une liste de vecteurs de localisation adaptée pour réaliser les images de vecteur permettant, par comparaison, de localiser la porte défaillante,
- dans une quatrième étape, on applique séquentiellement pas à pas la liste de vecteurs de localisation aux bornes d'entrée du circuit défaillant et/ou d'un circuit étalon, et on réalise et on enregistre un jeu d'images de vecteur pour les vecteurs de localisation de cette liste,
- dans une cinquième étape, on réalise l'étape de localisation de la porte défaillante en utilisant les images de vecteur réalisées à la quatrième étape.

Avantageusement et selon l'invention, chaque vecteur de localisation est formé de signaux binaires au format NRZ conservant le même état logique (0 ou 1) jusqu'à ce qu'un vecteur de localisation subséquent soit appliqué aux bornes d'entrée, ou, s'il s'agit du dernier vecteur de localisation, jusqu'à la fin de la(des) mesure(s) et/ou réalisation(s) d'image(s) effectuée(s) pour ce vecteur de localisation. Avantageusement et selon l'invention, on crée la séquence de vecteurs de localisation à partir d'une séquence de vecteurs, dits vecteurs de test, préalablement formée et enregistrée, et adaptée pour permettre de déterminer l'existence uniquement d'une porte défaillante dans le circuit défaillant par la mesure de la valeur du courant de consommation électrique au repos IDDQ du circuit défaillant, et on décompose chaque vecteur de test pour lequel le signal binaire d'au moins une borne d'entrée est susceptible de changer d'état logique, en une pluralité de vecteurs de localisation dont les signaux binaires ne changent pas d'état logique. Autrement dit, on convertit la séquence de vecteurs de test ayant permis de détecter l'existence d'un défaut, en une séquence de vecteurs de localisation au format NRZ.

Avantageusement et selon l'invention, on crée la séquence des vecteurs de localisation de sorte que deux vecteurs de localisation consécutifs sont distincts l'un de l'autre par la valeur d'un et un seul signal binaire appliqué à une et une seule borne d'entrée. Cette dernière variante présente notamment l'avantage d'accélérer ultérieurement la sélection de la(des) ligne(s) équipotentielle(s) correspondant à la porte défaillante.

Avantageusement et selon l'invention, avant de mesurer la valeur du courant de consommation au repos IDDQ, on mesure la valeur des courants circulant dans les bornes d'entrée et de sortie du circuit afin de s'assurer que le défaut est bien situé sur la puce.

Avantageusement et selon l'invention, pour mesurer la valeur du courant de consommation électrique au repos IDDQ du circuit défaillant, on applique au moins une borne d'alimentation -notamment ladite borne d'alimentation reliée à un potentiel bas VSS- du circuit défaillant, à l'entrée d'un circuit amplificateur monté en convertisseur courant/tension. Avantageusement, on utilise ladite borne d'alimentation reliée à un potentiel bas VSS, et le circuit amplificateur monté est un convertisseur courant/tension et est adapté pour créer une masse virtuelle ajustable selon les contraintes imposées par l'alimentation du circuit intégré sur lequel on mesure la valeur du courant IDDQ.

Par ailleurs, avantageusement et selon l'invention, on détermine si la valeur mesurée IDDQ(j) est normale ou anormale en la comparant à une valeur de courant de consommation électrique au repos nominale IDDQnom connue du circuit défaillant. Cette variante est possible quand on connaît déjà la valeur nominale de son courant de consommation au repos IDDQ.

Dans une autre variante, avantageusement et selon l'invention, on détermine si la valeur mesurée IDDQ(j) est normale ou anormale en calculant la différence normalisée :

$$D=[IDDQ(j)-IDDQ^0(j)]/maximum[IDDQ^0(j), Imin]$$

où

IDDQ(j) est la valeur mesurée du courant de consommation électrique au repos IDDQ du circuit défaillant avec le vecteur de test j,

$IDDQ^0(j)$ est la valeur mesurée du courant de consommation électrique au repos IDDQ d'un circuit étalon,

Imin est une valeur minimum de courant prédéterminée pour annihiler les effets de bruit. La valeur IDDQ(j) est considérée comme anormale si D est supérieure à une valeur seuil DS prédéterminée. Avantageusement et selon l'invention, on choisit DS compris entre 2 et 100.

Avantageusement et selon l'invention, après avoir effectué une première comparaison lors de laquelle au moins une zone de défaillance de la surface de la puce a été sélectionnée, on effectue au moins une comparaison ultérieure uniquement à partir d'images de vecteur correspondant à ladite zone de défaillance. Avantageusement et selon l'invention, pour un vecteur de localisation anormal, on effectue une comparaison de deux jeux d'images du circuit défaillant et/ou d'un circuit étalon, l'un au moins des deux jeux d'images étant un jeu d'images de vecteur obtenu avec ledit vecteur de localisation anormal, de façon à sélectionner une zone de défaillance dans laquelle la porte logique défaillante peut être située, et on effectue ensuite une comparaison ultérieure uniquement avec les jeux d'images de vecteur représentant ladite zone de défaillance.

Avantageusement et selon l'invention, lors d'une première comparaison de l'étape de localisation du défaut, on utilise à titre d'image de vecteur anormal, au moins une image de vecteur d'un jeu d'images de vecteurs obtenu avec le premier vecteur de localisation anormal apparaissant en premier dans la séquence de vecteurs de localisation. On sait en effet alors que tous les vecteurs de localisation précédents sont normaux, ce qui facilite ultérieurement la stratégie de recherche.

Dans le cas notamment d'une porte défaillante produisant un défaut de fonction électrique sur au moins une borne de sortie du circuit, on peut procéder de la façon suivante.

Avantageusement et selon l'invention, on teste la fonctionnalité électrique du circuit défaillant, et, dans le cas où le circuit défaillant s'avère être non fonctionnel pour au moins une borne de sortie, on utilise, à titre d'image de référence, une image de vecteur, dite image de référence défaut, obtenue avec le circuit défaillant pour un vecteur de localisation, dit vecteur de localisation normal, pour lequel la valeur mesurée du courant de consommation au repos IDDQ du circuit défaillant est normale. Avantageusement et selon l'invention, on utilise, à titre d'image de référence défaut, une image de vecteur obtenue avec le circuit défaillant, lors de la même séquence de vecteurs de localisation, avec un vecteur de localisation antérieur au vecteur de localisation anormal. Ces vecteurs de localisation utilisés sont enregistrés dans la liste de vecteurs sélectionnée dans la séquence pour permettre la localisation.

Avantageusement et selon l'invention, pour une comparaison, on utilise à titre d'image de vecteur anormal, une image de vecteur, dite image de vecteur anormal défaut, du circuit défaillant, et, pour comparer l'image de vecteur anormal défaut et l'image de référence défaut, on forme une image, dite image d'entrée défaut simple représentant les lignes équipotentielles du circuit défaillant qui sont de même forme, de même emplacement, et d'états de potentiel différents entre l'image de vecteur anormal défaut et l'image de référence défaut, de façon à être représentative de la ligne équipotentielle d'entrée de la porte logique défaillante.

Avantageusement et selon l'invention, on forme plusieurs images d'entrée défaut simples à partir d'une même image de vecteur anormal défaut que l'on compare à plusieurs images de référence défaut, et on forme une image, dite image d'entrée défaut intersection, représentant les lignes équipotentielles communes (mêmes forme, emplacement, et état de potentiel) entre les différentes images d'entrée défaut simples. Il est à noter que seul le circuit défaillant est utilisé pour localiser l'équipotentielle d'entrée.

Par ailleurs, l'invention permet en outre de localiser l'équipotentielle de sortie. Ainsi, avantageusement et selon l'invention, lors de l'étape de localisation de la porte défaillante, on effectue au moins une comparaison entre deux images d'un circuit étalon formées d'une image de vecteur anormal, dite image de vecteur anormal étalon, obtenue en appliquant à ce circuit étalon un vecteur de localisation anormal, et d'une image de référence, dite image de référence étalon, obtenue en appliquant au circuit étalon un vecteur de localisation normal. Avantageusement et selon l'invention, à partir de l'image de vecteur anormal étalon et de l'image de référence étalon, on forme une image, dite image d'entrée/sortie étalon simple, représentant les lignes équipotentielles du circuit étalon qui sont de même forme, de même emplacement, et d'états de potentiel différents entre l'image de vecteur anormal étalon et l'image de référence étalon, de façon à être représentative de la ligne équipotentielle d'entrée et de la ligne équipotentielle de sortie de la porte logique défaillante du circuit défaillant. Avantageusement et selon l'invention, on forme plusieurs images d'entrée/sortie étalon simples à partir d'une même image de vecteur anormal étalon que l'on compare à plusieurs images de référence étalon, et on forme une image, dite image d'entrée/sortie étalon intersection, représentant les lignes équipotentielles communes entre les différentes images d'entrée/sortie étalon simples. Avantageusement et selon l'invention, lors d'une comparaison ultérieure, on forme une image, dite image de sortie, représentant les lignes équipotentielles apparaissant sur une image d'entrée défaut simple ou sur une image d'entrée défaut intersection, ou sur une image d'entrée/sortie étalon simple, ou sur une image d'entrée/sortie étalon intersection, à l'exclusion des lignes équipotentielles communes entre ces images, cette image de sortie représentant la ligne équipotentielle de sortie de la porte logique défaillante et sa propagation dans le circuit défaillant. Pour localiser la porte logique défaillante, avantageusement et selon l'invention, on divise une image entrée défaut simple ou intersection et une image de sortie représentant la même portion de surface de la puce en fenêtres rectangulaires jointives de mêmes dimensions, fixes, prédéterminées, plus petites que celles de ces images, on examine pour chaque fenêtre si chacune des deux images présente ou non au moins une ligne équipotentielle, et on sélectionne et on enregistre la(les) fenêtre(s) présentant au moins une ligne équipotentielle dans chacune de ces deux images.

Dans le cas d'une porte logique défaillante qui ne produit pas de défaut fonctionnel sur une borne de sortie, on peut procéder de la façon suivante.

Avantageusement et selon l'invention, on teste la fonctionnalité électrique du circuit défaillant et, dans le cas où le circuit défaillant s'avère être fonctionnel pour toutes les bornes de sortie, on effectue une comparaison entre au moins une première image de vecteur anormale obtenue avec un premier vecteur de localisation anormal et au moins une deuxième image de vecteur anormal obtenue avec le même circuit et avec un deuxième vecteur de localisation anormal distinct du premier vecteur de localisation anormal, les premier et deuxième vecteurs de localisation anormaux appartenant à la même séquence de vecteurs de localisation. Avantageusement et selon l'invention, on forme une image, dite image de sortie défaut, représentant la(les) lignes équipotentielle(s) qui est(sont) commune(s) aux différentes images de vecteur anormal, comprenant la ligne équipotentielle de sortie de la porte logique défaillante. Avantageusement et selon l'invention, lors d'une comparaison ultérieure, on forme une image, dite image de sortie intermédiaire, représentant les lignes équipotentielles apparaissant en commun sur l'image de sortie défaut et sur au moins une image de vecteur normal obtenue avec un vecteur de localisation normal, à l'exclusion des lignes équipotentielles communes entre cette image de sortie défaut et cette image de vecteur normal, ladite image de sortie intermédiaire comprenant la ligne équipotentielle de sortie de la porte logique défaillante. Avantageusement et selon l'invention, lors d'une comparaison ultérieure, on forme une image, dite image de sortie, représentant les lignes équipotentielles communes à l'image de sortie défaut et à l'image de sortie intermédiaire, ladite image de sortie représentant la ligne équipotentielle de sortie de la porte logique défaillante.

Par ailleurs, avantageusement et selon l'invention, on réalise les images de test par microscopie électronique à balayage en contraste de potentiel par détection des électrons secondaires. Toute autre méthode fournissant des images contrastées représentatives des niveaux de potentiel est utilisable en variante. Avantageusement et selon l'invention, on enregistre les images de vecteur sous forme pixelisée, monochromes, et on effectue chaque comparaison entre images sous forme pixelisée, par voie numérique, pixel par pixel.

En outre, avantageusement et selon l'invention, avant d'utiliser une image dans une étape de comparaison d'images, on réalise préalablement une intégration de cette image sur plusieurs clichés identiques correspondant à cette image, et un filtrage médian en affectant à chaque pixel la valeur médiane de l'ensemble de pixels comprenant ce pixel et les pixels qui l'entourent, de façon à supprimer les pics dus au bruit.

Par ailleurs, avantageusement et selon l'invention, pour former une image représentant les lignes équipotentielles qui sont de même forme, de même emplacement, et d'états de potentiel différents entre deux images de départ, on réalise, pixel par pixel, une différence des deux images de départ selon la formule :

$$PC=(PA-PB)/2 + INT(E/2)$$

où PA est la valeur de niveau de contraste du pixel de la première image d'entrée ; PB est la valeur de niveau de contraste du pixel de la deuxième image d'entrée ; E est la valeur maximum de niveau de contraste des images ; PC est la valeur de niveau de contraste du pixel de l'image formée ; INT est la fonction partie entière. Classiquement E est égal à 255, les images comprenant 256 niveaux de contraste de 0 à 255.

En outre, avantageusement et selon l'invention, pour former une image représentant les lignes équipotentielles communes (mêmes forme, emplacement et état de potentiel) entre deux images de départ, on réalise :

- une étape de seuillage adaptatif à trois niveaux de contraste blanc, noir, gris, de valeurs correspondant respectivement à E, 0 et à une valeur au moins sensiblement médiane entre 0 et E -notamment INT (E/2)-,
- pixel par pixel, une intersection étendue AND+ lors de laquelle on affecte à chaque pixel de l'image à former les niveaux de contraste suivants :

  . noir (0) si les deux pixels des images de départ sont noirs à l'issue du seuillage adaptatif,
  . blanc (E) si les deux pixels des images de départ sont blancs à l'issue du seuillage adaptatif,
  . gris (INT(E/2)) dans tous les autres cas.

De même, avantageusement et selon l'invention, pour former une image représentant les lignes équipotentielles de l'une ou l'autre de deux images de départ, à l'exclusion des lignes équipotentielles communes à ces deux images de départ, on réalise :

- une étape de seuillage adaptatif à trois niveaux de contraste blanc, noir, gris,
- pixel par pixel, une comparaison par OU exclusif étendu XOR+ lors de laquelle on affecte à chaque pixel de l'image à former, les niveaux de contraste suivants :

  . gris (INT(E/2)) si les deux pixels des images de départ ont le même niveau de contraste à l'issue du seuillage adaptatif,
  . blanc (E) si les deux pixels des images de départ sont blanc et gris ; ou blanc et noir ; ou gris et noir à l'issue du seuillage adaptatif,
  . noir (0) si les deux pixels des images de départ sont noir et gris ; ou noir et blanc ; ou gris et blanc.

Plus généralement, avantageusement et selon l'invention, lorsque l'on veut comparer deux images dont l'une est représentative du circuit défaillant, tandis que l'autre est représentative d'un circuit étalon, on réalise au préalable un traitement des images comprenant une étape de seuillage adaptatif, pixel par pixel, à trois niveaux de contraste blanc, noir, gris.

L'invention s'étend à une installation de mise en oeuvre d'un procédé selon l'invention.

L'invention concerne donc une installation de localisation d'un défaut de type court-circuit, d'une porte logique, dite porte logique défaillante, d'un circuit intégré, dit circuit défaillant, comprenant une puce des bornes d'entrée et des bornes de sortie reliées les unes aux autres par des pistes électriquement conductrices et des portes logiques formées au sein de la puce du circuit en forme générale de plaquette définissant un plan principal de la puce, les pistes s'étendant dans l'épaisseur de la puce ou en surface, globalement parallèlement au plan principal, les bornes d'entrée et de sortie étant reliées aux pistes à la périphérie de la puce, et au moins deux bornes d'alimentation en énergie électrique sous tension continue (VDD-VSS), dont au moins une borne d'alimentation est reliée à un potentiel haut VDD et au moins une borne d'alimentation reliée à un potentiel bas VSS, ladite installation comprenant :

- des moyens pour créer et enregistrer une séquence de vecteurs distincts, dits vecteurs de localisation, formés chacun d'un ensemble de signaux adaptés pour pouvoir être appliqués aux différentes bornes d'entrée du circuit défaillant,
- des moyens d'imagerie d'équipotentielles aptes à réaliser et à enregistrer, pour au moins un vecteur de localisation appliqué aux bornes d'entrée du circuit défaillant et/ou d'un circuit intégré, dit circuit étalon, exempt de porte défaillante et de tout défaut, et identique par ailleurs au circuit défaillant, un jeu d'images, dites images de vecteur, représentant des lignes équipotentielles formées par les pistes et les portes logiques dudit circuit, chaque ligne équipotentielle correspondant à l'un des états de potentiel différenciés sur les images de vecteur, les différentes images de vecteur d'un même jeu d'images étant adaptées pour couvrir et représenter toute la surface de la puce ou toute une portion de cette surface sur laquelle on cherche à localiser la porte logique défaillante,

caractérisée en ce qu'elle comprend :

- des moyens de formation d'une séquence de vecteurs de localisation dans laquelle chaque vecteur de localisation est formé de signaux binaires prenant l'un des états logiques 0 et 1 et conservant cet état logique pendant toute une durée pendant laquelle le vecteur de localisation est considéré comme étant appliqué aux bornes d'entrée,
- des moyens pour appliquer pas à pas la séquence de vecteurs de localisation aux bornes d'entrée du circuit défaillant,
- des moyens de mesure pour chaque vecteur de localisation, de la valeur IDDQ(j) du courant de consommation électrique au repos IDDQ du circuit défaillant circulant dans l'une au moins des bornes d'alimentation,
- des moyens de calcul aptes à déterminer si cette valeur mesurée IDDQ(j) est normale ou anormale et à enregistrer le résultat de cette détermination,
- des moyens de calcul aptes à effectuer au moins une comparaison entre au moins une image de vecteur anormal et une autre image préenregistrée, dite image de référence, correspondant à une même portion de surface de la puce du circuit défaillant ou du circuit étalon que l'image de vecteur anormal, ces images étant choisies pour que cette comparaison permette de sélectionner une zone, dite zone de défaillance, de la surface de la puce sur laquelle peut être située une ligne équipotentielle d'entrée de la porte logique défaillante et/ou une ligne équipotentielle de sortie de la porte logique défaillante et/ou la porte logique défaillante.

Avantageusement et selon l'invention, les moyens de mesure de la valeur du courant de consommation électrique au repos IDDQ du circuit, comprennent un circuit amplificateur monté en convertisseur courant/tension. Avantageusement et selon l'invention, le circuit amplificateur monté en convertisseur courant/tension est adapté pour créer une masse virtuelle ajustable selon les contraintes imposées par l'alimentation du circuit.

L'invention permet ainsi de réduire considérablement le temps nécessaire à la localisation d'une porte défaillante en ne travaillant que sur les images utiles, et dans des conditions permettant de faciliter les opérations de comparaison. Elle permet de localiser une porte défaillante ne produisant pas de défaut fonctionnel et de travailler sur des circuits intégrés dépassivés ou non encore passivés.

L'invention permet en fait de localiser la porte défaillante dès lors que l'on dispose :

- de la séquence de vecteurs de localisation, que l'on peut élaborer à partir d'une séquence de vecteurs de test standard ;
- d'un circuit défaillant pour détecter et enregistrer les vecteurs de localisation anormaux ;
- d'un circuit défaillant et/ou d'un circuit étalon pour acquérir les images à comparer.

L'invention permet non seulement de localiser la porte défaillante, mais, du fait de la certitude de cette localisation, de l'identifier grâce aux dessins des masques de fabrication ("layout") si l'on dispose de ces dessins. On peut alors ensuite caractériser physiquement le défaut et comprendre son origine avec une très grande fiabilité et une très grande précision. Le procédé selon l'invention peut être automatisé et exécuté en majeure partie par voie informatique, en réduisant l'intervention humaine au strict nécessaire.

L'invention concerne également un procédé et une installation caractérisés en combinaison par tout ou partie des caractéristiques sus-mentionnées ou décrites ci-après.

D'autres buts, caractéristiques et avantages de l'invention apparaîtront à la lecture de la description suivante qui se réfère aux figures annexées dans lesquelles :

- la figure 1 est une vue schématique d'une installation selon l'invention,
- la figure 2 est une vue schématique illustrant les moyens de mesure de la valeur du courant de consommation électrique au repos IDDQ d'une installation selon l'invention,
- la figure 3 est un organigramme des étapes d'un procédé selon l'invention pour la création de la séquence de vecteurs de localisation, la mesure du courant IDDQ et la recherche et l'enregistrement des vecteurs de localisation anormaux,
- les figures 4a, 4b, 4c sont un exemple de trois diagrammes illustrant sur trois signaux d'entrée VAL, CLOCK, IN-X, la conversion d'une séquence de vecteurs de test, en une séquence de vecteurs de localisation selon l'invention,
- la figure 5 est un organigramme illustrant un procédé permettant d'exécuter la conversion d'une séquence de vecteurs de test en une séquence de vecteurs de localisation selon l'invention,
- la figure 6 est un schéma illustrant différents formats connus de signaux de vecteurs de tests,
- les figures 7a et 7b sont deux diagrammes illustrant, respectivement, deux variantes de détermination du caractère normal ou anormal, de la valeur mesurée du courant de consommation électrique au repos IDDQ d'un circuit intégré défaillant dans un procédé selon l'invention,
- la figure 8 est un organigramme illustrant un procédé de mesure du courant IDDQ, de détermination du caractère normal ou anormal de chaque vecteur de localisation, et de création et d'enregistrement du résultat de cette détermination,
- la figure 9 est un organigramme illustrant les étapes d'un procédé selon l'invention pour l'acquisition des images de vecteur,
- les figures 10a, 10b 10c sont des schémas illustrant des étapes de comparaison d'images d'un procédé selon l'invention, dans le cas d'une porte défaillante présentant un défaut de court-circuit affectant la fonction électrique en sortie,
- les figures 11a, 11b sont des schémas illustrant des étapes de comparaison d'images d'un procédé selon l'invention dans le cas d'une porte défaillante présentant un défaut n'affectant pas la fonction en sortie (défaut léger),
- les figures 12a et 12b sont des schémas illustrant des étapes de comparaison d'images d'un procédé selon l'invention appliqué au cas d'un circuit exempt de couche de passivation,
- la figure 13 est un exemple d'histogramme d'une image d'une portion de surface de circuit obtenue par microscopie électronique un contraste de potentiel ayant subie un traitement d'intégration et de filtrage médian,
- la figure 14 est un schéma illustrant la division d'images en rectangles pour une étape de seuillage adaptatif d'un procédé selon l'invention,

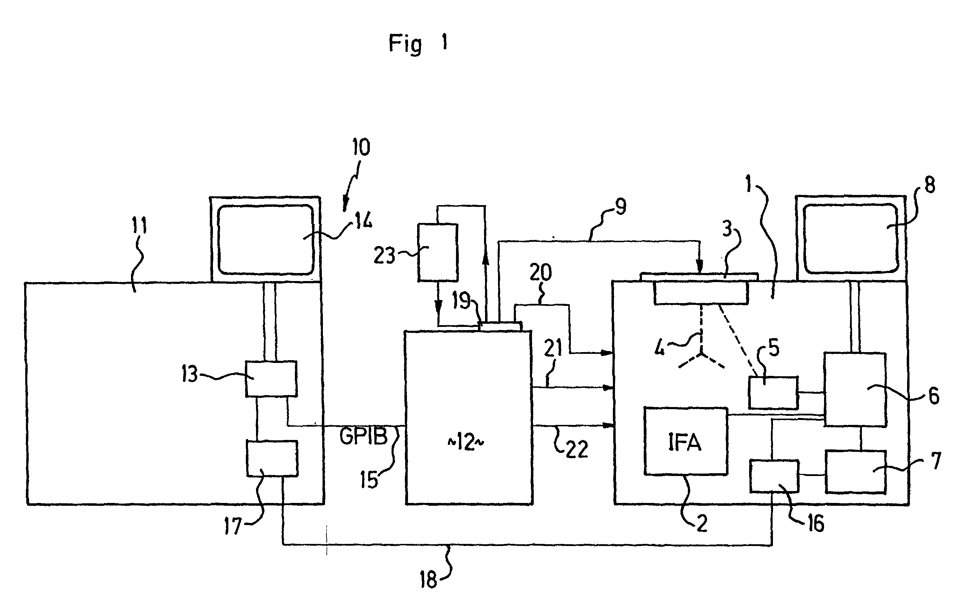

L'installation représentée figure 1 comprend un système 1 d'imagerie par microscopie électronique en contraste de potentiel par détection des électrons secondaires. Un tel système est connu en lui-même et est par exemple un système IDS 5000 HX commercialisé par la Société SCHLUMBERGER TECHNOLOGIES (FRANCE), doté d'une carte IFA ("Image fault analysis") pour mettre en oeuvre la technique dite CGFI et du système de programmation d'interfaces API ("application programming interface") IDSCMD, l'ensemble permettant de contrôler le microscope et de programmer l'acquisition des images souhaitées de la surface d'un circuit intégré en contraste de potentiel. Les caractéristiques générales de ce système sont bien connues, leur connaissance est implicite, et seules les caractéristiques concernant l'invention sont décrites.

Les images fournies par ces système 1 d'imagerie sont des images en contraste du potentiel pixelisées monochromes présentant une échelle E de niveaux de contraste, en général de 256 niveaux de contraste numérotés 0 à 255. Le système 1 d'imagerie comprend un support 3 de circuit intégré doté de moyens de réglage de sa position transversale X-Y par rapport à un faisceau d'électrons 4 émis par des moyens d'émission pour irradier la surface du circuit intégré dont on veut réaliser les images.

Les électrons secondaires réémis sont captés par un détecteur 5 fournissant le signal à une unité 6 informatique de traitement et de calcul dotée d'une mémoire de masse 7 apte à permettre l'enregistrement des images, et les différents périphériques traditionnels d'une station de travail informatique (clavier, souris...) dont un écran d'affichage 8.

Le support 3 est adapté pour permettre de placer le circuit intégré dans une chambre sous vide dans laquelle le faisceau d'électrons 4 est émis, alors que les broches d'entrée et de sortie du circuit intégré sont électriquement reliées à l'extérieur de la chambre par un faisceau de câbles 9 à un système 10 de commande de test de circuits intégrés.

Le système 10 de commande de test est aussi connu en lui-même et est par exemple un système HP 82000 équipé du logiciel HP 82000 et de l'extension "TABULAR LINK", commercialisé par la Société HEWLETT PACKARD (FRANCE). Les caractéristiques générales de ce système sont bien connues, leur connaissance est implicite, et seules les caractéristiques concernant l'invention sont décrites. Ce système comprend une station 11 informatique de traitement et de calcul et une unité de commande électrique, dite testeur LSI 12, qui met en forme et gère les différents signaux à appliquer à un circuit intégré à analyser. La station 11 et le testeur LSI 12 sont reliés ensemble de façon connue par un bus 15 de commande GPIB.

La station 11 comprend une carte mère 13 à microprocesseur, des mémoires vives et de masse associées, les différents périphériques traditionnels associés (clavier, souris...) dont un écran 14 d'affichage.

La station 11 du système 10 de commande de test est aussi reliée à l'unité 6 du système 1 d'imagerie par un réseau informatique de type ETHERNET formé d'une carte réseau 16 associée à l'unité, d'une carte réseau 17 de la station 11 et d'un câble réseau 18 reliant ces cartes réseau 16, 17.

Le testeur LSI 12 comprend une carte de connexion 19 de laquelle sont issues les différentes voies de commande et d'alimentation du circuit intégré, et qui est reliée par le faisceau de câble 9 au circuit intégré placé dans le système 1 d'imagerie.

Par ailleurs, le testeur LSI 12 est relié à la carte IFA 2 du système 1 d'imagerie par un câble 20 reliant une voie, IDS_SYNC, de la carte de sortie 19, un câble 21 transmettant un signal de déclenchement TRIGGER OUT du système 10 de commande, et un câble 22 transmettant un signal d'horloge EXT_CLOCK du système 10 de commande au système 1 d'imagerie.

Le testeur LSI 12 reçoit en outre une carte 23 de mesure du courant de consommation électrique au repos IDDQ du circuit intégré placé sur le support 3. Sur la figure 1, cette carte 23 est représentée à l'extérieur du testeur LSI 12, mais il doit être compris que cette carte 23 peut être intégrée à l'intérieur de ce testeur LSI 12.

La carte de sortie 19 du testeur LSI 12 comprend aussi des bornes VDD1, VDD2, VDD3, VDD4 d'alimentation du circuit intégré à un potentiel haut VDD, et au moins une borne VSS d'alimentation du circuit intégré à un potentiel bas VSS. Contrairement au branchement normal, la borne VSS d'alimentation de la carte de connexion 19 n'est pas reliée directement à la masse 24 du testeur LSI 12, mais est reliée à l'entrée positive d'un amplificateur opérationnel 25 de la carte 23 de mesure du courant IDDQ. La masse 24 du testeur LSI 12, reliée à la terre, est connectée sur l'autre entrée négative de l'amplificateur opérationnel 25. L'amplificateur opérationnel 25 est par exemple un AD795, et est choisi pour accepter un très faible courant d'entrée.

La carte 23 de mesure IDDQ comprend un circuit adapté pour créer une masse virtuelle pour le circuit intégré sur la borne VSS, dont la valeur peut être ajustée selon les contraintes imposées pour l'alimentation du circuit intégré. Ce circuit est aussi adapté pour former un convertisseur courant/tension, de sorte que le signal fourni par la carte 23 au testeur LSI 12 est un signal de tension compatible avec ce testeur LSI 12.

En effet, un tel testeur LSI 12 est normalement adapté pour recevoir des signaux en tension, et n'est pas conçu pour mesurer des courants. L'amplificateur opérationnel 25 comprend, entre sa borne négative et sa sortie, une résistance parallèle R et une capacité parallèle C. La résistance R permet d'ajuster la sensibilité en courant de la carte 23 de mesure qui est par exemple de 0,1μA pour R=10kΩ, et de 10nA pour R=100kΩ. La sensibilité en tension est de 1 mV. La sortie de l'amplificateur opérationnel 25 est reliée à l'entrée positive d'un deuxième amplificateur opérationnel 26, identique au précédent, qui forme un second étage suiveur, son entrée négative étant reliée à sa sortie.

La sortie de ce deuxième amplificateur opérationnel 26 forme la sortie 27 de la carte de mesure 23 qui est reliée à l'une des voies libres de la carte de connexion 19 du testeur LSI 12, de sorte que le signal de mesure du courant IDDQ est fourni par le testeur LSI 12 à la station 11 par l'intermédiaire du bus 15.

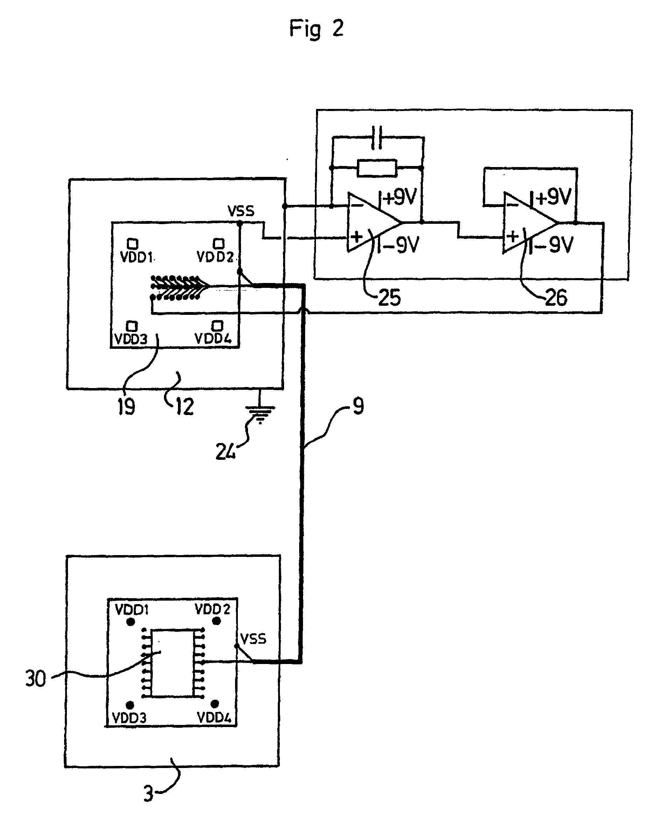

La carte de mesure 23 permet ainsi de mesurer le courant consommé par le circuit intégré, circulant entre la borne VSS d'alimentation du circuit intégré et la masse 24 du testeur LSI 12. Le circuit intégré, référencé 30 figure 2, est placé sur le support 3 et est relié par le faisceau de câbles 9 à l'une au moins des bornes d'alimentation VDD1, VDD2, VDD3, VDD4 à un potentiel haut, et à la borne VSS d'alimentation au potentiel bas VSS, correspondant à la masse du support 3 qui est isolée de la masse du système 1 d'imagerie.

La station 11 est programmée (logiciel HP 82000) pour permettre la commande du testeur LSI 12 et l'envoi sur le circuit intégré 30 qui lui est relié d'une séquence de vecteurs, chaque vecteur étant formé d'un ensemble de signaux adaptés pour être appliqués aux différentes bornes d'entrées du circuit intégré 30.

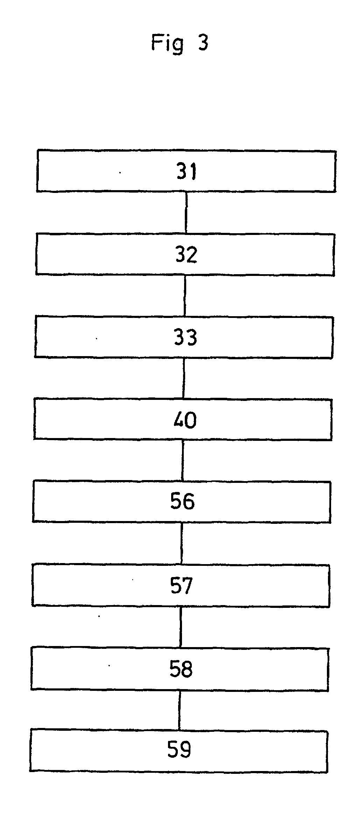

La figure 3 représente les premières étapes d'un procédé selon l'invention que l'on exécute lorsque l'on dispose d'un circuit intégré défaillant sur lequel on recherche à localiser une porte logique défaillante. Le circuit intégré défaillant 30 est placé sur le support 3. Lors de l'étape 31, on réalise un test de caractérisation électrique traditionnel du circuit intégré 30 lors duquel on mesure le courant consommé par chacune des bornes d'entrée et de sortie. On compare ces valeurs aux spécifications fournies par le fabricant pour vérifier qu'aucun défaut ne vient de l'extérieur de la puce du circuit intégré 30.

Dans l'étape 32 subséquente, on adapte la configuration électrique du testeur LSI 12 du circuit intégré 30, de façon connue en soi, en connectant les différentes voies de la carte de connexion 19 aux bornes d'entrée et de sortie appropriées du circuit 30, et en saisissant les paramètres correspondants sur la station 11, notamment les différents formats des broches du circuit intégré 30.

Lors de l'étape subséquente 33, on transmet à la station 11 une séquence de vecteurs de test ayant préalablement servi à déterminer que le circuit 30 est défaillant, et on convertit cette séquence de vecteurs de test en une séquence de vecteurs de localisation, au format NRZ, appropriée pour la localisation de défaut.

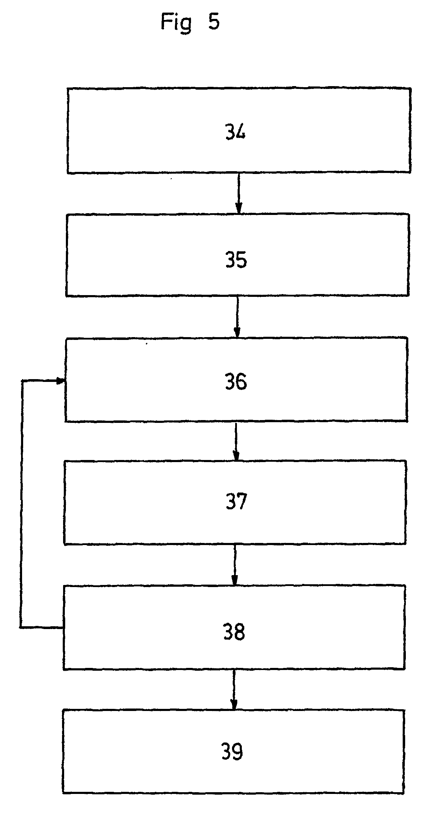

Le procédé effectué lors de l'étape 33 est programmé sur la station 11 par exemple en langage de programmation HPVee. Il est schématisé figure 5.

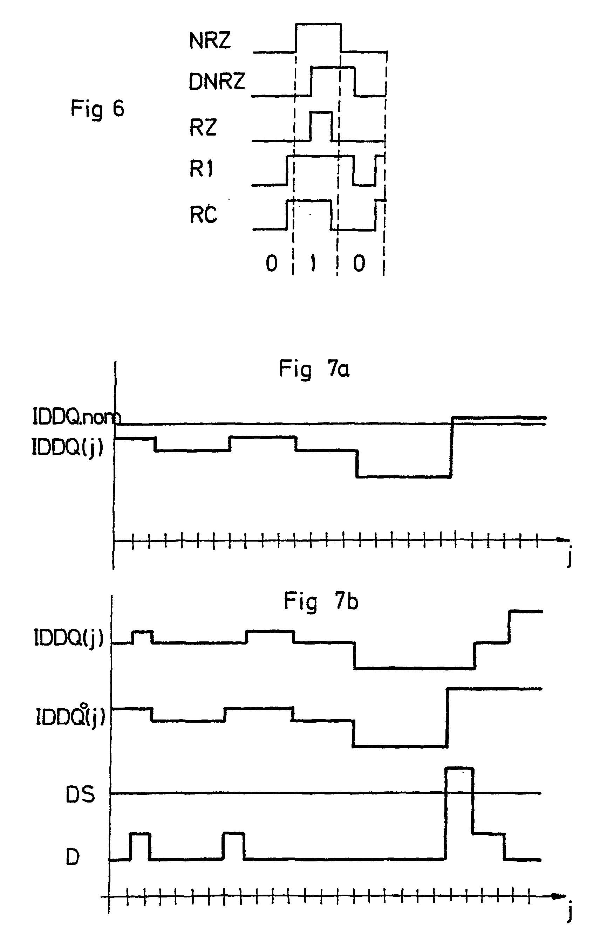

Lors de l'étape 34, on lit les formats utilisés pour chaque broche d'entrée dans les vecteurs de test. Ces formats peuvent être NRZ, DNRZ, RZ, R1 ou RC comme représentés sur la figure 6 qui donne, selon ces formats, l'exemple des changements d'état logique pour un signal de vecteur prenant successivement les valeurs 0, 1 et 0.

Lors de l'étape 35, on écrit un tableau représentant, par ordre chronologique, les changements d'état logique (front de début LE ou front de fin TE) des différents signaux. Un exemple de ce tableau est le tableau suivant :

| TEMPS | LE | TE | NOM | FORMAT |
|-------|----|----|-----|--------|
| 10 | X | | IN-X | R1 |
| 20 | X | | CLOCK | RZ |
| 20 | | X | VAL | DNRZ |
| 40 | | X | CLOCK | RZ |
| 50 | | X | IN-X | R1 |

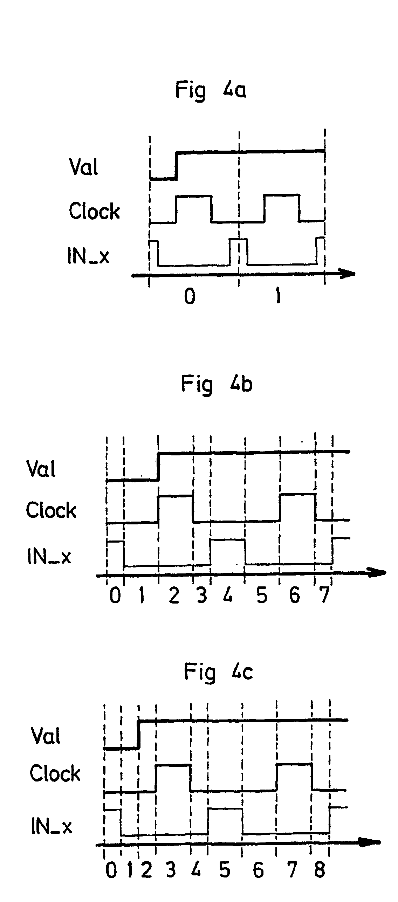

Ce tableau 1 est celui obtenu avec les signaux VAL, CLOCK et IN-X des vecteurs de test de la figure 4a. Il permet de déterminer les changements d'états logiques lors de chaque valeur du signal de chaque vecteur de test.

Lors de l'étape 36, on parcourt la séquence de vecteurs de test progressivement, du premier vecteur de test au dernier, et, pour chaque vecteur de test on recherche dans le tableau, lors de l'étape 37, selon les changements de valeur des signaux, les temps auxquels se produisent successivement les éventuels changements d'état logique. Dès qu'un changement d'état logique (LE ou TE) d'au moins un signal est trouvé pour ce vecteur de test, on crée une coupure du vecteur correspondant à ce temps. Autrement dit, on découpe le vecteur de test, lors de l'étape 38, en autant de vecteurs de localisation qu'il y a de changements d'états logiques apportés par ce vecteur de test par rapport à l'état logique des signaux au vecteur de test précédent. On réitère les étapes 36, 37, 38 pour découper ainsi tous les vecteurs de test en une séquence de vecteurs de localisation pour lesquels tous les signaux sont au format NRZ (leur valeur, correspondant à leur état logique, ne variant pas au cours du temps pour chaque vecteur) que l'on mémorise lors de l'étape 39. On obtient alors une séquence de vecteurs de localisation telle que représentée figure 4b.

Il est à noter qu'une telle séquence de vecteurs de localisation peut aussi être créée non pas à partir d'une séquence de vecteurs de test, mais directement, par exemple en prenant des signaux NRZ.

L'intérêt de partir d'une séquence de vecteurs de test que l'on transforme, est d'être sûr de reproduire le défaut du circuit intégré dont l'existence a été précédemment mise en évidence.

Après avoir effectué cette étape 33 de conversion des vecteurs, on applique, lors de l'étape 40 (figure 3), la séquence de vecteurs de localisation en mode pas à pas aux bornes d'entrée du circuit intégré 30. Pour chaque vecteur de localisation, on mesure la valeur du courant IDDQ du circuit intégré défaillant 30. Lors de cette étape 40, on détecte les vecteurs de localisation anormaux pour lesquels la valeur du courant IDDQ est anormale, selon un procédé de comparaison par rapport à une valeur seuil prédéterminée. Si l'on connaît une valeur nominale IDDQnom du courant IDDQ du circuit défaillant, on utilise cette valeur à titre de valeur de seuil et on considère que la valeur mesurée est anormale lorsqu'elle dépasse cette valeur nominale IDDQnom (figure 7a).

Dans une autre variante, on détermine si la valeur mesurée IDDQ(j) est normale ou anormale en calculant la différence normalisée

$$D=[IDDQ(j)-IDDQ^0(j)]/maximum[IDDQ^0(j), Imin]$$

où

IDDQ(j) est la valeur mesurée du courant de consommation électrique au repos IDDQ du circuit défaillant avec le vecteur de test j,

$IDDQ^0(j)$ est la valeur mesurée du courant de consommation électrique au repos IDDQ d'un circuit étalon,

Imin est une valeur minimum de courant prédéterminée pour annihiler les effets de bruit, la valeur IDDQ(j) étant considérée comme anormale si D est supérieure à une valeur seuil DS prédéterminée.

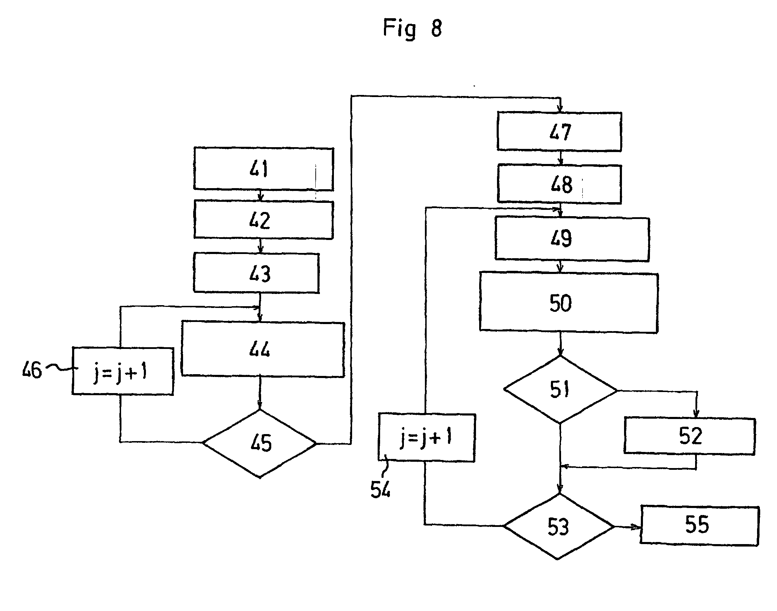

La figure 8 représente un organigramme du procédé de comparaison correspondant à cette deuxième variante.

Lors de l'étape 41, on place un circuit intégré étalon exempt de porte défaillante et de tout défaut et qui est identique au circuit défaillant à analyser sur le support 3. On lance lors de l'étape 42 la séquence de vecteurs de localisation, et le premier vecteur de localisation est appliqué aux bornes d'entrée de ce circuit lors de l'étape 43, une variable j de dénombrement des vecteurs étant initialisée égale à 1. Lors de l'étape 44, on mesure la valeur du courant de consommation électrique au repos IDDQ du circuit étalon pour le vecteur de localisation j=1, puis on teste dans l'étape 45 si la valeur de la variable j est la dernière ou non. Si tel n'est pas le cas, on incrémente cette valeur j d'une unité lors de l'étape 46 pour passer aux vecteurs de localisation subséquents.

On enregistre ainsi lors de l'étape 44 les différentes valeurs $IDDQ^0$ (j) du courant IDDQ pour les différents vecteurs de localisation et pour le circuit étalon.

Lorsqu'on est arrivé au dernier vecteur de la séquence des vecteurs de localisation, on place le circuit intégré défaillant sur le support 3 lors de l'étape 47. On applique le premier vecteur de localisation aux bornes d'entrée du circuit lors de l'étape 48, et on réinitialise la variable j à 1. On mesure et on enregistre la valeur mesurée IDDQ(j) du courant de consommation électrique au repos du circuit lors de l'étape 49, puis on calcule lors de l'étape 50 la différence normalisée D. Lors de l'étape 51, on détermine si la différence D est supérieure ou non à la valeur seuil DS. Si tel est le cas, on enregistre lors de l'étape 52 que le vecteur de localisation correspondant est un vecteur de localisation anormal. Sinon, on passe à l'étape de test 53 lors de laquelle on examine si le vecteur de localisation est le dernier ou non. S'il existe encore un vecteur de localisation, on incrémente la variable j d'une unité lors de l'étape 54 pour réitérer les étapes 49 à 53, et ce jusqu'au dernier vecteur de la séquence de vecteurs de localisation, après lequel on termine le procédé de comparaison lors de l'étape 55.

La valeur seuil DS pour la différence normalisée est avantageusement choisie comprise entre 2 et 100, notamment entre 5 et 20, par exemple égale à 10. La valeur minimum de courant Imin est avantageusement choisie égale à 10nA avec le testeur HP 82000.

La figure 7b représente un exemple de variation de la valeur mesurée IDDQ(j) et de détermination d'un vecteur de localisation anormal.

A la fin de l'étape 40 (figure 3), on dispose de la liste des vecteurs de localisation anormaux.

Lors de l'étape 56 subséquente, on réexamine les vecteurs de localisation anormaux afin de les redécouper de telle sorte que deux vecteurs de localisation anormaux consécutifs soient distincts l'un de l'autre par la valeur d'un et un seul signal binaire au format NRZ appliqué à une et une seule borne d'entrée du circuit, comme représenté figure 4c.

Ainsi, à l'issue de l'étape de conversion 33 susdécrite, les vecteurs de localisation sont au format NRZ comme représenté figure 4b. A partir des deux vecteurs de test de la figure 4a, l'étape 33 de conversion a permis de créer sept vecteurs de localisation comme représenté figure 4b. Comme on le voit sur cette figure, les signaux VAL et CLOCK commutent simultanément entre le vecteur 1 et le vecteur 2. Si le vecteur 1 est un vecteur anormal, on procède alors lors de l'étape 56 à un décalage temporel de l'un des deux signaux VAL ou CLOCK, de façon à créer un nouveau vecteur de localisation intermédiaire, pour obtenir la séquence représentée figure 4c.

Compte tenu du très faible nombre de vecteurs de localisation anormaux en général détecté, ce redécoupage peut être effectué manuellement. Rien n'empêche néanmoins de programmer ce redécoupage sur la station 11.

Lors de l'étape 57, on procède à une nouvelle mesure du courant IDDQ pour chacun des vecteurs de localisation traité lors de l'étape 56 de redécoupage. On détermine alors si ces vecteurs de localisation sont normaux ou anormaux, de la même façon qu'à l'étape 40 sus-décrite.

Lors de l'étape 58 subséquente, on met à jour la liste des vecteurs anormaux. Lors de l'étape 59 subséquente, on adresse au système 1 d'imagerie via le réseau 16, 17, 18, le nombre de vecteurs de la séquence de localisation, la liste des vecteurs de localisation anormaux, et la fréquence de fonctionnement du circuit intégré. A partir de ces valeurs, le système 1 d'imagerie acquiert les images nécessaires à l'étape de localisation de la porte défaillante.

Le système 1 d'imagerie et sa carte IFA permet d'acquérir des images selon la méthode dite CGFI. Alors qu'un vecteur de localisation est appliqué aux bornes d'entrée du circuit défaillant ou d'un circuit étalon placé sur le support 3, le système 1 permet de réaliser et d'enregistrer un jeu d'images, dite images de vecteur, représentant des lignes équipotentielles formées par les pistes des portes logiques dudit circuit, chaque ligne équipotentielle correspondant à l'un des états de potentiel différenciés sur les images de vecteurs. Les différentes images de vecteur, rectangulaires, d'un même jeu d'images sont adaptées pour couvrir et représenter toute la surface de la puce ou toute une portion de cette surface sur laquelle on cherche à localiser la porte logique défaillante.

Le signal IDS_SYNC adressé par le testeur LSI 12 au système 1 permet de synchroniser l'acquisition des images par rapport au déroulement des vecteurs de localisation appliqués par le testeur LSI 12 au circuit intégré.

Le système 1 d'imagerie est programmé pour acquérir, non pas toutes les images de la surface de la puce pour tous les vecteurs de localisation comme dans l'art antérieur, mais uniquement des jeux d'images particuliers correspondant à des vecteurs de localisation particuliers prédéfinis comme décrit ci-après. A partir de ces images de vecteur particulières, le système 1 d'imagerie est programmé pour exécuter une étape de localisation de la porte défaillante lors de laquelle il effectue au moins une comparaison entre au moins une image de vecteur, dite image de vecteur anormale, acquise alors qu'on appliquait un vecteur de localisation anormal au circuit intégré, et une autre image préenregistrée, dite image de référence, choisie pour que cette comparaison permette de sélectionner une zone, dite zone de défaillance, de la surface de la puce sur laquelle peut être située une ligne équipotentielle d'entrée de la porte logique défaillante et/ou une ligne équipotentielle de sortie de la porte logique défaillante et/ou la porte logique défaillante elle-même.

La programmation du système 1 d'imagerie est effectuée à l'aide des commandes de programmation d'interface d'application, dites API ("Application programming interface") IDSCMD, qui constituent un système de programmation permettant d'écrire des scripts de commande pour acquérir les images souhaitées sur les zones de la surface de la puce présélectionnée.

Les API utilisées pour la configuration du système 10 de commande de test (HP82000) et du système 1 d'imagerie (IDS 5000 HX) en vue de l'acquisition synchrone des images (fixant notamment la durée d'application du vecteur, dite "HOLD", et la durée d'acquisition des images) peuvent être les suivantes:

```
idscmd ids_sem_oi_set MC_DelayON
idscmd ids_sem_oi_set IfaSetupSvncNeg
idscmd ids_sem_oi_set hwGateWidth
idscmd ids_sem_oi_set HoldTime
idscmd ids_sem_oi_set hwDelay
idscmd ids_sem_oi_set MC_sem_imagetest
idscmd ids_sem_oi_set SetupTesterInteractAuto
idscmd ids_sem_oi_set IfaSetupSyncEnable
idscmd ids_sem_oi_set hp
idscmd ids_sem_oi_set ethernet
idscmd ids_sem_oi_set hwGateWidth
idscmd ids_sem_oi_set HoldTime
idscmd ids_sem_oi_set hwDelay
```

L'API permettant l'activation de la carte IFA pour l'acquisition d'une image est la suivante :

```
idscmd ids_sem_oi_set MC_image_test
```

L'API utilisée pour contrôler le déplacement du faisceau d'électrons et l'acquisition d'un jeu d'images peuvent être les suivantes :

```
ids_sem_get_expected_position
ids_sem_get_current_position
ids_sem_set_position x y
ids_sem_get_micron_per_pixel
```

Les API utilisées pour la manipulation des images peuvent être les suivantes :

```
ids_sem_load_image filename
ids_sem_store_image filename
```

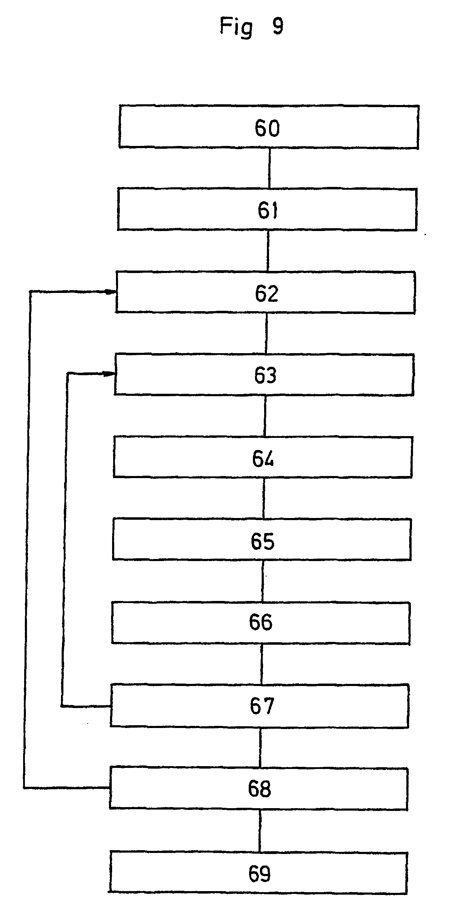

La figure 9 représente un organigramme du procédé mis en oeuvre pour l'acquisition des images pour chaque vecteur de localisation prédéterminé.

Lors de l'étape 60, le système 1 d'imagerie calcule le temps de maintien de chaque vecteur de localisation ("HOLD") nécessaire pour acquérir les images correspondant à ce vecteur. Cette valeur est fournie au système 11 de commande par le réseau 16, 17, 18. Elle est calculée en fonction notamment de la fréquence de fonctionnement du circuit que le système 1 d'imagerie a reçu précédemment du système 11 de commande.

Lors de l'étape 61, le système 1 d'imagerie calcule la durée d'acquisition totale des différentes images (compte tenu notamment du nombre d'images à acquérir pour chaque jeu d'images et du nombre de vecteurs de localisation concernés). Cette durée est utilisée pour maintenir le système 1 d'imagerie actif pendant une période suffisamment longue pour acquérir toutes les images souhaitées.

Lors de l'étape 62, le système 1 d'imagerie sélectionne le premier vecteur de localisation pour lequel un jeu d'images doit être réalisé. Il prépare ensuite lors de l'étape 63 l'acquisition d'une première image de vecteur du jeu d'images en déplaçant le faisceau d'électrons au regard de la zone correspondante de la surface de la puce du circuit 30 placé sur le support 3.

Lors de l'étape 64, le système 1 d'imagerie envoie un signal par le réseau 16, 17, 18 au système 11 de commande de façon que celui-ci commande le testeur et place le signal de synchronisation IDS_SYNC pendant toute la durée du vecteur à acquérir.

Lors de l'étape 65, le système 1 d'imagerie acquiert n fois l'image correspondante, alors que le vecteur de localisation est appliqué au circuit intégré 30. Par exemple, on choisit n=16 de sorte que chaque image est acquise 16 fois successivement.

Lors de l'étape 66, le système 1 d'imagerie réalise une intégration des n images identiques en affectant à chaque pixel la valeur moyenne obtenue sur les n images pour ce pixel. On effectue ensuite un filtrage médian en affectant à chaque pixel la valeur médiane de l'ensemble de pixels formé de ce pixel et des pixels qui l'entourent, de façon à supprimer les pics dus au bruit et à fournir une image unique moyennée pixelisée monochrome de la portion de surface de la puce.

L'intégration des images permet de réduire le bruit ergodique et stationnaire. Le filtrage médian permet de supprimer les pics de bruit sans affecter la dynamique ni le contraste des images. Ces opérations sont effectuées par voie numérique, pixel par pixel.

Lors de cette étape 66, on enregistre l'image ainsi obtenue.

Lors de l'étape 67 subséquente, on examine s'il y a lieu d'acquérir d'autres images du même jeu d'images pour le même vecteur de localisation. Dans l'affirmative, on retourne à l'étape 63 pour déplacer le faisceau d'électrons en regard de la portion de surface de la puce correspondant à l'acquisition d'une autre image, puis en effectue les étapes 64, 65 et 66 permettant d'acquérir et de mémoriser l'image correspondante. Toutes les images ont le même format rectangulaire, généralement carré.

Dans la négative, on examine lors de l'étape 68 subséquente si un autre jeu d'images pour un autre vecteur de localisation doit être effectué. Dans l'affirmative, on retourne à l'étape 62 lors de laquelle le système 1 d'imagerie envoie une requête au système 11 de commande pour appliquer un autre vecteur de localisation. On exécute ensuite pour ce vecteur de localisation l'ensemble des étapes 63 à 67 permettant d'acquérir les différentes images de vecteur du jeu d'images. Dans la négative, c'est-à-dire s'il n'y a plus de vecteur de localisation pour lequel les images doivent être acquises, on interrompt le procédé d'acquisition d'images et on réalise l'étape de localisation de la porte défaillante, à partir des différentes images acquises et enregistrées.

Lors de chaque étape de comparaison, on compare deux images d'une même portion de la surface de la puce, dites images de départ, et on forme une autre image, dite image résultat, à partir d'un traitement automatique effectué par le système 1 d'imagerie sur les deux images de départ.

Plusieurs types de traitement peuvent être appliqués aux images de départ pour former un image résultat. Dans un premier type de traitement, dit différence, on forme une image résultat représentant les lignes équipotentielles qui sont de mêmes formes et d'états de potentiel différents -notamment opposés- entre les deux images de départ. Pour ce faire, on réalise, pixel par pixel, une différence des deux images de départ selon la formule :

$$PC=(PA-PB)/2 + INT(E/2)$$

où PA est la valeur de niveau de contraste du pixel de la première image d'entrée ; PB est la valeur de niveau de contraste du pixel de la deuxième image d'entrée ; E est la valeur maximum de niveau de contraste des images ; PC est la valeur du pixel de l'image formée ; et INT est la fonction partie entière.

Ce traitement de différence est appliqué sur deux images de départ acquises sur le même circuit, à savoir soit sur le circuit défaillant, soit sur un circuit étalon. Ce traitement de différence met en évidence les différences entre deux états électriques distincts correspondant à deux vecteurs de localisation distincts, divise le bruit des images par deux, diminue l'effet de la topographie et, en masquant les états communs entre les deux images de départ (les pixels de niveaux de contraste semblables des images de départ apparaissant dans les gris dans l'image formée), diminue la quantité d'informations à traiter ultérieurement.

Lors d'un deuxième type de traitement, on forme une image résultat représentant les lignes équipotentielles communes entre les deux images de départ. Ce traitement, dit intersection étendue AND+, consiste à former l'image résultat en affectant à chacun de ses pixels les niveaux de contraste suivants :

- noir si les deux pixels des images de départ sont noirs,
- blanc si les deux pixels des images de départ sont blancs,
- gris dans tous les autres cas.

Lors d'un troisième type de traitement, l'image résultat représente les lignes équipotentielles de l'une ou l'autre des deux images de départ à l'exclusion des lignes équipotentielles communes à ces deux images de départ. Ce traitement est dit OU exclusif étendu XOR+. Pour réaliser ce traitement, on forme chaque pixel de l'image résultat en lui affectant le niveau de contraste suivant :

- gris si les deux pixels des images de départ ont le même niveau de contraste,
- blanc si les deux pixels des images de départ sont l'un blanc et l'autre gris ; ou l'un blanc et l'autre noir ; ou l'un gris et l'autre noir,
- noir si les deux pixels des images de départ sont l'un noir et l'autre gris ; ou l'un noir et l'autre blanc ; ou l'un gris et l'autre blanc. Il est à noter que l'ordre dans lequel on examine les deux images de départ a une importance dans ce traitement XOR+.

Par ailleurs, avantageusement et selon l'invention, on réalise un traitement de seuillage adaptatif à trois niveaux de contraste, blanc, noir, gris, des images de départ. Une telle étape de seuillage adaptatif est avantageusement prévue préalablement à une comparaison par intersection étendue et/ou par OU exclusif étendu de façon à éviter toute erreur d'affectation des niveaux de contraste lors de ces traitements. Par contre, le traitement de différence peut être effectué sur des images de départ n'ayant pas subi préalablement un seuillage adaptatif.

L'étape de seuillage adaptatif d'une image est effectuée comme décrit ci-après.

L'image est une image pixelisée (de type "BITMAP") comprenant b colonnes de pixels et c lignes de pixels. Dans cette image, on cherche à distinguer au plus trois niveaux de contraste correspondant aux états logiques normaux de potentiels : noir (0), gris (INT(E/2)) et blanc (E).

Dans l'image formée par le système 1 d'imagerie, on ne peut pas distinguer les trois niveaux de contraste blanc, noir, gris correctement car leurs niveaux de contraste réels pouvant correspondante à ces valeurs normalement se chevauchent. Ainsi, la valeur maximum correspondant normalement au noir peut être supérieure à la valeur minimum du niveau de contraste réel correspondant normalement au gris, et la valeur maximum du niveau de contraste réel correspondant normalement au gris peut être supérieure à la valeur minimum du niveau de contraste réel correspondant normalement au blanc.

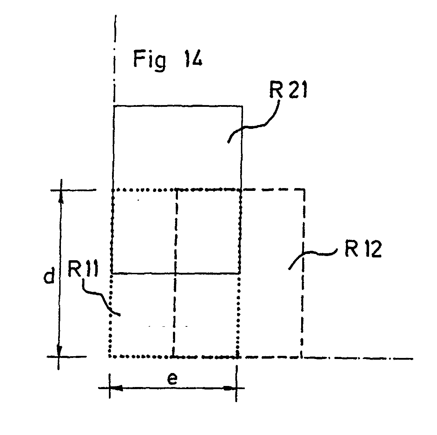

On définit sur l'image de départ des rectangles de longueur d et de largeur e en commençant par le bord inférieur gauche de l'image comme représenté figure 14. Si chacun de ces rectangles est désigné Rik, i représentant le numéro des rectangles en ligne et k représentant le numéro des rectangles en colonne, le premier rectangle est le rectangle R11 situé dans le coin inférieur gauche de l'image. Le rectangle suivant est le rectangle R12 dont on voit qu'il chevauche le rectangle R11 sur la moitié de sa largeur. De même, le rectangle R21 situé au-dessus du rectangle R11 chevauche ce dernier sur la moitié de sa hauteur. Ainsi, et selon l'invention, les différents rectangles se chevauchent les uns les autres à mi-hauteur et mi-largeur.

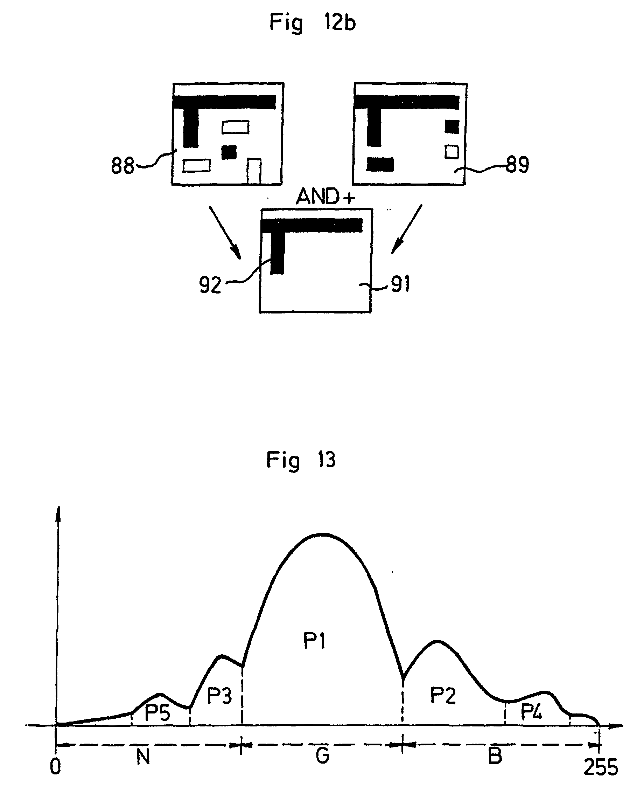

Dans chaque rectangle, on détermine s'il y a un niveau de contraste, deux niveaux de contraste, ou trois niveaux de contraste, et on affecte à chaque pixel des objets identifiés dans le rectangle, l'un seulement des différents niveaux de contraste noir, gris et blanc. Pour cela, on utilise l'histogramme des niveaux de contraste de chaque rectangle (figure 13). L'histogramme est la courbe représentant en abscisse les niveaux de contraste de 0 à E=255 et en ordonnées les nombres de pixels pour chaque niveau de contraste. Cet histogramme possède un niveau de contraste minimum NGmin, un niveau de contraste maximum NGmax, un niveau de contraste moyen NGmoy et un écart type ETNG des niveaux de contraste.

On détermine tout d'abord le nombre de niveaux de contraste du rectangle. On fixe tout d'abord une taille minimum de chaque objet correspondant à un rectangle de fxg pixels, avec $f \leq g$ ; $f \geq e/10$ ; et $g \geq d/10$. Ces conditions permettent à partir de la connaissance de la taille des pistes du circuit intégré, de déterminer les valeurs de d et e appropriées.

On sait par ailleurs que, dans l'image complète d'une portion de surface d'une puce d'un circuit intégré, le gris correspondant au fond de l'image est majoritaire. On détermine que les trois niveaux de contraste sont présents dans un rectangle si l'histogramme du rectangle présente au moins trois pics (points maximums) principaux distincts, et si l'une au moins des deux conditions suivantes est réalisée :

    1) NGmoy$\geq$S1 et (NGmax-NGmin)/NGmoy$\geq$S2
    2) NGmax-NGmin$\geq$S3 et ETNG$\geq$S4

Si les deux conditions mentionnées ci-dessus ne sont pas réalisées, on détermine qu'il y a deux niveaux de contraste dans le rectangle lorsque les différentes conditions suivantes sont réalisées :

    1) il existe au moins deux pics principaux distincts dans l'histogramme du rectangle,
    2) NGmax - NGmim $\geq$ S5,
    3) ETNG $\geq$ S6.

Les valeurs seuil S1, S2, S3, S4, S5 et S6 sont prédéterminées expérimentalement à partir d'images connues d'un circuit intégré bien connu du même type.

Si aucune des conditions précédentes n'est réalisée, on considère qu'il n'y a qu'un seul niveau de contraste dans le rectangle.

A partir de l'histogramme du rectangle Rik dont un exemple est représenté figure 13, (après intégration et filtrage médian) on sépare les différents pics par des lignes verticales à partir des minima. On calcule ensuite la surface de chacun des pics que l'on classe par ordre d'importance, et on sélectionne les trois pics les plus importants que l'on utilise pour délimiter les trois niveaux de contraste. Comme on le voit figure 13, le pic le plus important est le pic central P1, le deuxième pic le plus important est le pic P2 situé immédiatement à droite du pic P1, le troisième pic le plus important est le pic P3 situé immédiatement à gauche du pic P1, les pics P4 et P5 étant de moindre importance. Les lignes de séparation des pics P1 et P2 et P1 et P3 sont donc les frontières entre les niveaux de contraste noir N, gris G et blanc B comme représenté figure 13. Il est à noter que l'ensemble de ce traitement est effectué automatiquement par calcul à partir de l'histogramme du rectangle Rik.

Si le rectangle contient les trois niveaux de contraste, on affecte à chaque pixel le niveau de contraste noir, blanc ou gris correspondant selon le découpage de l'histogramme indiqué ci-dessus. De préférence, le niveau de contraste noir correspond à la valeur 0, le niveau de contraste blanc correspond à la valeur E (par exemple 255), et le niveau de contraste gris correspond à la valeur INT(E/2) (par exemple 127). Il est à noter que d'autres valeurs pourraient être choisies, à savoir une valeur faible (égale ou non à 0), une valeur forte (égale ou non à E), et une valeur médiane, de façon à définir trois niveaux de contraste distincts équilibrés.

Si le rectangle Rik contient un ou deux niveaux de contraste, les objets de niveaux de contraste communs des rectangles voisins servent à affecter les bons niveaux de contraste aux pixels de ce rectangle. En effet, les rectangles se chevauchant, chaque pixel de la partie médiane de l'image appartient à plusieurs rectangles différents (jusqu'à quatre rectangles si on exclut les frontières, et jusqu'à neuf rectangles si on inclut les frontières). Dans le cas où un rectangle a un ou deux niveaux de contraste, on examine les autres rectangles comprenant ce pixel pour déterminer quel est son niveau de contraste.

Dans l'hypothèse où aucun rectangle de l'image ne contient les trois niveaux de contraste, ceux-ci sont affectés de la façon suivante : s'il n'y a qu'un niveau de contraste, on choisit le gris ; s'il y a deux niveaux de contraste, celui le plus fréquemment rencontré (nombre de pixels) est affecté au gris, et l'autre est le noir si la valeur des pixels est inférieure, ou le blanc si la valeur des pixels est supérieure. Si nécessaire, une intervention humaine peut être admise pour affecter les niveaux de contraste dans des cas rares complexes où l'on ne peut pas affecter ces niveaux de contraste par calcul de proche en proche par voie entièrement automatique.

Après avoir affecté ces niveaux de contraste, on effectue un filtrage médian permettant de supprimer le bruit. On réassemble ensuite les différents rectangles, dans lesquels chaque pixel a reçu l'un des trois niveaux de contraste, pour reconstituer l'image.

A l'issue de cette étape de seuillage adaptatif, l'image obtenue ne comprend que trois niveaux de contraste : noir (0), gris (127) et blanc (255).

En outre, après chaque étape de traitement de type intersection étendue AND+ ou OU exclusif étendu XOR+, ou de seuillage adaptatif, on effectue une étape, dite étape de réduction, lors de laquelle on réalise un filtrage médian puis une érosion et une dilatation des pixels noirs ou blancs. Ce traitement d'érosion ou de dilatation de pixels permettant de supprimer les pixels en saillie ou en creux non significatifs est connu en lui-même. Avec un tel traitement, un pixel isolé est supprimé, un pixel en saillie par rapport à un bloc de même niveau de contraste est supprimé, et un pixel en creux dans un bloc de niveaux de contraste différents est replacé au niveau de contraste du bloc. Les groupes de pixels sont donc reformés en blocs polygonaux.

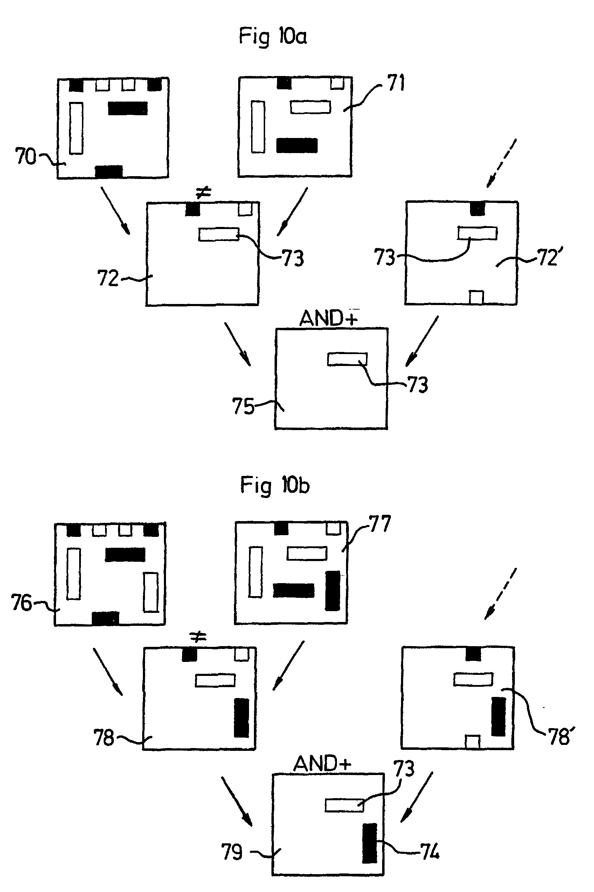

Les figures 10a, 10b, 10c illustrent les différentes étapes de comparaison d'images dans le cas d'une porte logique défaillante présentant un défaut de court-circuit affectant la fonction électrique en sortie du circuit intégré. Dans une première étape de comparaison représentée figure 10a, on utilise deux images de la même zone du circuit intégré défaillant, à savoir une image de vecteur anomal, dite image de vecteur anormal défaut 70, et une image de vecteur, dite image de référence défaut 71, obtenue avec le circuit défaillant pour un vecteur de localisation normal pour lequel la valeur du courant IDDQ est normale. A partir de ces deux images 70, 71, on forme une image, dite image défaut simple, représentant les lignes équipotentielles du circuit défaillant qui sont de mêmes formes, de même emplacement, et d'états potentiel différents opposés, de façon à être représentative de la ligne équipotentielle à l'entrée de la porte logique défaillante. Cette image d'entrée défaut simple est obtenue par différence des images vecteur anormal défaut 70 et de référence défaut 71.

Pour former l'image de référence défaut, on utilise un vecteur de localisation normal, qui est par exemple tout vecteur antérieur au premier vecteur de localisation anormal de la séquence de vecteur de localisation. En effet, on sait que tous les vecteurs de localisation qui sont antérieurs au premier vecteur de localisation anormal, sont normaux. Il est à noter à ce titre que dans la quasi-totalité des cas, le circuit défaillant ne comprend qu'une seule porte logique défaillante.

On forme en outre plusieurs images d'entrée défaut simple telle que l'image 72 à partir d'une même image de vecteur anormal défaut 70 que l'on compare à plusieurs images de référence défaut telles que l'image 71. Sur la figure 10a, on a représenté ainsi une deuxième image d'entrée défaut simple 72' qui est obtenue par différence à partir de l'image d'entrée défaut simple 70 et d'une autre image de référence défaut. Toutes les images d'entrée défaut simples ont en commun la ligne équipotentielle d'entrée 73 de la porte logique défaillante du circuit. Il est en effet certain qu'entre une image de vecteur anormal et une image de vecteur normal, la ligne équipotentielle d'entrée de la porte défaillante a changé d'état de potentiel, et donc de niveau de contraste. Par contre, le défaut correspondant à un court-circuit, la sortie de la porte logique défaillante n'est pas modifiée.

Il est à noter que les images de vecteur anormal défaut 70 et de référence défaut 71 sont des images issues de la microscopie électronique ayant subi des traitements d'intégration et de filtrage médian uniquement. Ainsi, les figures 10a à 12b représentent des images simplifiées, mais il doit être entendu en pratique qu'il ne s'agit là que d'une représentation schématique, les images étant dans la pratique beaucoup plus complexes.

On réalise ensuite un traitement de seuillage adaptatif sur les différentes images d'entrée défaut simples 72, 72'.... obtenues, comme indiqué ci-dessus, puis un traitement de réduction de chacune de ces images.

On compare ensuite les images d'entrée défaut simples 72, 72' deux à deux, et en cascade, en formant en final, une image, dite image d'entrée défaut intersection 75 représentant les lignes équipotentielles communes entre les différentes images d'entrée défaut simples. Cette image d'entrée défaut intersection 75 représente la ligne équipotentielle d'entrée 73 de la porte logique défaillante, et en général, uniquement cette ligne équipotentielle. Il suffit en effet de choisir un nombre suffisant d'images d'entrée défaut simples 72, 72'...pour aboutir à cette ligne équipotentielle 73 unique sur l'image 75. Pour former l'image d'entrée défaut intersection 75, on réalise une intersection étendue AND+ entre les différentes images d'entrée défaut simples 72, 72'..., comme décrit ci-dessus.

Par ailleurs, pour trouver la ligne équipotentielle de sortie du défaut, on effectue au moins une comparaison entre deux images d'un circuit étalon comme représenté figure 10b. On utilise une image de vecteur anormal, dite image de vecteur anormal étalon 76, obtenue en appliquant au circuit étalon (placé dans le support 3) un vecteur de localisation anormal. On utilise à titre d'image de référence, une image dite image de référence étalon 77, obtenue en appliquant au circuit étalon un vecteur de localisation normal. On effectue la différence de ces deux images pour obtenir l'image 78 sur laquelle on sait que les lignes équipotentielles d'entrée 73 et de sortie 74 de la porte défaillante sont représentées. Cette image, dite image d'entrée/sortie étalon simple 78, représente les lignes équipotentielles du circuit étalon qui sont de même forme, de même emplacement, et d'états de potentiel différents entre l'image de vecteur anormal étalon 76 et l'image de référence étalon 77.

De même que précédemment, on forme plusieurs images d'entrée/sortie étalon simples 78, 78'... à partir de la même image de vecteur anormal étalon 76 que l'on compare, par différence, à plusieurs images de référence étalon telles que l'image de référence étalon 77. On forme ensuite, en comparant deux à deux et en cascade les différentes images d'entrée/sortie étalon simples 78, 78', une autre image dite image d'entrée/sortie étalon intersection 79, représentant les lignes équipotentielles communes entre les différentes images d'entrée/sortie étalon simples 78, 78', c'est-à-dire la ligne équipotentielle d'entrée 73 et la ligne équipotentielle de sortie 74 de la porte logique défaillante. Pour former cette image d'entrée/sortie étalon intersection 79, on réalise l'intersection étendue AND+ des différentes images d'entrée/sortie étalon simples 78, 78' comme indiqué ci-dessus.

Il est possible, comme représenté figure 10c, d'effectuer une comparaison ultérieure lors de laquelle on forme une image, dite image de sortie 80, représentant uniquement la ligne équipotentielle de sortie de la porte logique défaillante, et sa propagation dans le circuit défaillant. Pour ce faire, on réalise un OU EXCLUSIF ÉTENDU XOR+ à partir de l'image d'entrée défaut intersection 75 et de l'image d'entrée/sortie intersection 79.

Il est à noter que pour former l'image d'entrée/ sortie intersection, on réalise préalablement sur les images d'entrée/sortie simples 78, 78', un traitement de seuillage adaptatif et de réduction. Egalement, avant de réaliser le OU exclusif étendu des images entrée défaut intersection 75 et entrée/sortie intersection 79, on réalise un traitement de réduction de ces images. Du fait des différents traitements intervenus précédemment, il est alors de possible de comparer, sans risque d'erreur, les deux images 75, 79, bien que celles-ci n'aient pas été effectuées avec le même circuit intégré. Par contre, il est à noter que les images complexes issues de l'imagerie ne sont comparées entre-elles (par différence) que lorsqu'elles proviennent d'un même circuit, soit le circuit défaillant, soit un circuit étalon.

L'image de sortie 80 est aussi soumise à un traitement de réduction.

L'invention permet ainsi de façon simple et entièrement automatisée de former des images 75, 80 représentatives de la ligne d'entrée 73 uniquement et de la ligne de sortie 74 uniquement de la porte logique défaillante. A partir de ces images 75, 80, il est possible de localiser précisément la porte logique défaillante, et ce de façon automatique.

On sait que la distance entre la sortie et l'entrée de la porte logique défaillant est faible et que c'est à partir de la sortie de la porte logique défaillante que l'on à intérêt à parcourir les lignes équipotentielles. En effet, la défaillance d'une porte logique est en général le résultat d'un défaut physique situé sur la ligne équipotentielle de sortie.

On découpe les images 75, 80 en rectangles comme indiqué précédemment en ce qui concerne le traitement de seuillage adaptatif, à l'exception du fait que les différents rectangles ne se chevauchent pas les uns les autres mais se jouxtent bord à bord.

On recherche les rectangles dans lesquels l'image de sortie 80 et l'image d'entrée défaut intersection 75 comprennent toutes deux au moins un objet dont le niveau de contraste normal est soit blanc soit noir (présence de pixels blancs ou noirs).

Pour ce faire, on réalise un OU exclusif étendu XOR+ entre le rectangle de l'image d'entrée défaut intersection 75 et un rectangle de mêmes dimensions entièrement gris, puis on soumet l'image du rectangle obtenue à un traitement de réduction. Si cette image n'est pas entièrement grise, c'est-à-dire comprend des pixels noirs et/ou blancs, on procède au même traitement à partir du même rectangle de l'image de sortie 80 en réalisant le OU exclusif étendu XOR+ de ce rectangle de l'image de sortie avec un rectangle de mêmes dimensions entièrement gris. L'image obtenue est soumise à un traitement de réduction. Si cette image n'est pas non plus entièrement grise, on réalise alors un nouveau OU exclusif étendu XOR+ entre les images obtenues précédemment, pour obtenir une image finale. On soumet l'image finale à un traitement de réduction. Cette image finale représente une zone dans laquelle le défaut correspondant à la porte logique défaillante est situé.

Si en effectuant ce traitement, on aboutit à plusieurs zones dissociées de l'image dans lesquelles le défaut de la porte logique défaillante est susceptible d'être situé, on peut réitérer le procédé en utilisant une dimension pour les rectangles plus petite. Si au contraire, on ne trouve aucune zone dans laquelle le défaut est susceptible de se situer, on réitère le procédé avec une dimension de rectangle plus importante, en longueur et/ ou en largeur. On peut commencer avec des rectangles de mêmes dimensions (d et e) que ceux utilisés pour le traitement de seuillage adaptatif, comme décrit ci-dessus. Finalement, avec ce procédé, on peut obtenir une et une seule zone précise dans laquelle la porte logique défaillante est localisée.

Il est à noter à nouveau que l'ensemble de toutes ces opérations peut être réalisé entièrement par programmation d'ordinateur, par calcul numérique et traitement d'informations. Les seuls éléments d'intervention de l'utilisateur consiste en la fixation des différentes valeurs de seuil statistique utilisées pour le seuillage adaptatif selon le type de circuit intégré examiné. La fixation de ces valeurs se fait expérimentalement. A titre d'exemple, pour des circuits intégrés CMOS en technologie de $0,7\mu$ à $1,5\mu$ à deux niveaux de métal et un niveau poli, et avec le système 1 d'imagerie mentionné ci-dessus, on utilise les valeurs seuil suivantes : S1=100, S2=1,3, S3=160, S4=47, S5=130, S6=20. Pour déterminer ces valeurs seuil, on peut utiliser des images connues de circuits intégrés dont les niveaux de potentiel sont connus, dont on calcule les niveaux de contraste minimum, maximum, moyen et l'écart type.

Il est à noter également que cette opération de seuillage adaptatif qui peut être automatisée permet ensuite d'effectuer des comparaisons d'images par voie numérique à l'aide d'opérateur logiques de type AND+ et XOR+ (et non à l'aide d'opérateurs de type arithmétique) rendant ces opérations beaucoup plus rapides et simples.

Egalement, il est à noter que l'utilisation du découpage des images en rectangles qui se chevauchent ou non dans les différents traitements (rectangles qui se chevauchent pour le seuillage adaptatif, rectangles jointifs pour la recherche de la porte défaillante) permet d'accélérer considérablement la vitesse de traitement puisqu'il n'est pas nécessaire d'effectuer un calcul pour chaque pixel. Chaque rectangle peut avoir classiquement une dimension de 10 à 100 pixels en largeur et en hauteur, et ainsi incorporer entre 100 et 10000 pixels.

En outre, selon l'invention, après avoir effectué une première étape de comparaison lors de laquelle une ou plusieurs zones de défaillance de la surface de la puce ont été sélectionnées, il n'est pas nécessaire d'effectuer ultérieurement des comparaisons sur toutes les images des jeux d'images. On peut en effet effectuer les comparaisons ultérieures uniquement à partir d'images de vecteurs correspondant à ladite(aux) zone(s) de défaillance ainsi présélectionnée(s). Par exemple, l'opération AND+ effectuée sur des images d'entrée défaut simples 72, 72' peut n'être exécutée que sur les images ayant un donné un résultat à l'issue de la différence des images initiales 70, 71. En effet, il est rappelé que la surface de la puce du circuit nécessite pour sa représentation, un jeu de plusieurs images, classiquement 512 images jointives. Les premières comparaisons doivent être effectuées sur les 512 images correspondant aux vecteurs de localisation choisis, mais les comparaisons ultérieures ne sont effectuées que sur certaines des images du jeu d'images correspondant à la zone de défaillance préalablement sélectionnée.

Avantageusement, on utilise lors de la première comparaison de l'étape de localisation du défaut, une image de vecteur obtenue avec le premier vecteur de localisation anormal apparaissant en premier dans la séquence de vecteur de localisation. De la sorte, la zone de défaillance sélectionnée a de très fortes probabilités d'être limitée en dimension.

En conséquence, le procédé selon l'invention est très rapidement convergent, et il s'est avéré en pratique que les portes logiques défaillantes peuvent être localisées à partir d'un faible nombre d'images de départ. En général, deux étapes de différence d'images du circuit défaillant 70, 71 et deux étapes de différence d'images du circuit étalon 76, 77 sont suffisantes. On n'a donc à acquérir et à comparer que deux jeux d'images du circuit défaillant, puis deux séries d'images du circuit étalon correspondant aux zones de défaillance sélectionnées avec le circuit défaillant.

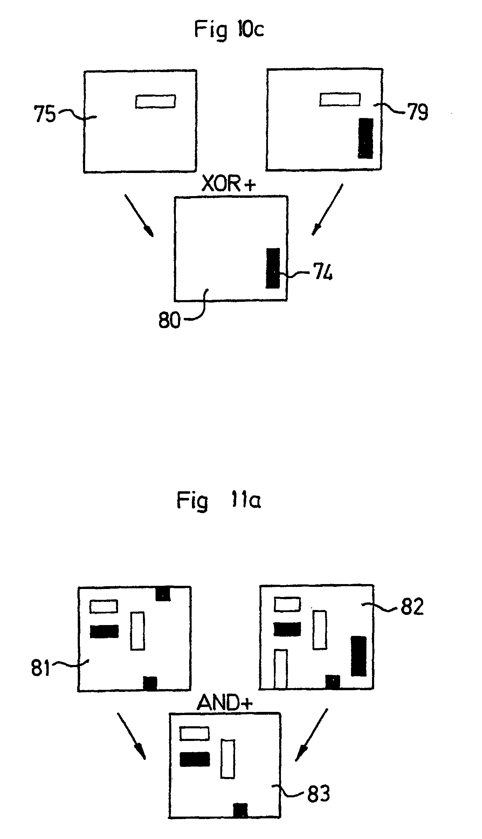

Les figures 11a et 11b représentent une variante de l'invention applicable dans le cas où le circuit défaillant s'avère être fonctionnel pour toutes ses bornes de sortie. Dans ce cas, le défaut n'est qu'un défaut léger qui risque d'apparaître ultérieurement lors de l'utilisation mais qui ne peut pas être détecté dans l'art antérieur puisqu'aucune borne de sortie ne présente de défaut. Dans ce cas, il n'est pas utile d'utiliser un circuit étalon, puisque le circuit défaillant présente les mêmes fonctionnalités que le circuit étalon.

Dans l'étape représentée figure 11a, on effectue une comparaison entre au moins deux images de vecteur anormal 81, 82 obtenues avec deux vecteurs de localisation anormaux distincts appartenant à la même séquence de vecteurs de localisation. On forme une image, dite image de sortie défaut 83, représentant les lignes équipotentielles qui sont communes aux images de vecteur anormal 81, 82, et comprenant la ligne équipotentielle de sortie 87 de la porte logique défaillante. Pour ce faire, on réalise une intersection étendue AND+ entre les images 81 et 82 pour obtenir l'image de sortie défaut 83. Préalablement, les images 81 et 82 ont subi un seuillage adaptatif et un traitement de réduction. Egalement, l'image 83 subit ultérieurement un traitement de réduction.

On peut réitérer cette opération avec d'autres images de vecteur anormal distinctes de 81 et 82, et en réaliser l'intersection étendue AND+, puis réaliser l'intersection étendue des différentes images de sortie défaut ainsi obtenues, pour obtenir, en final, l'image de sortie défaut 83 la plus précise possible, et ce, selon le nombre de vecteurs de localisation anormaux de la séquence.

Lors de l'étape ultérieure représentée figure 11b, on utilise l'image de sortie défaut 83 que l'on compare par la fonction OU exclusif étendu XOR+ à une image de vecteur normal 84 obtenue avec un vecteur de localisation normal sur le même circuit. L'image 85 résultante consiste en l'union de ces deux images 83, 84 dont on a extrait des lignes équipotentielles communes entre ces deux images. On élimine ainsi en particulier les lignes équipotentielles d'entrée qui ne sont pas celles de la porte logique défaillante. On peut réitérer cette opération OU exclusif étendu XOR+ en utilisant plusieurs images de vecteur normal 84 et en effectuant ensuite l'intersection étendue AND+ entre les différentes images ainsi obtenues. Il est à noter que les images de vecteur normal 84 ont subi préalablement un traitement de seuillage adaptatif et de réduction.

L'image 85 ainsi obtenue est ensuite comparée à nouveau à l'image de sortie défaut 83 par une intersection étendue AND+ de façon à former une image, dite image de sortie 86, représentant la ligne équipotentielle de sortie 87 de la porte logique défaillante.

Comme précédemment, avant chaque comparaison par intersection étendue AND+ ou OU exclusif étendu XOR+, les images sont soumises à un traitement de réduction. De même, l'image de sortie 86 est ultérieurement soumise à un traitement de réduction.

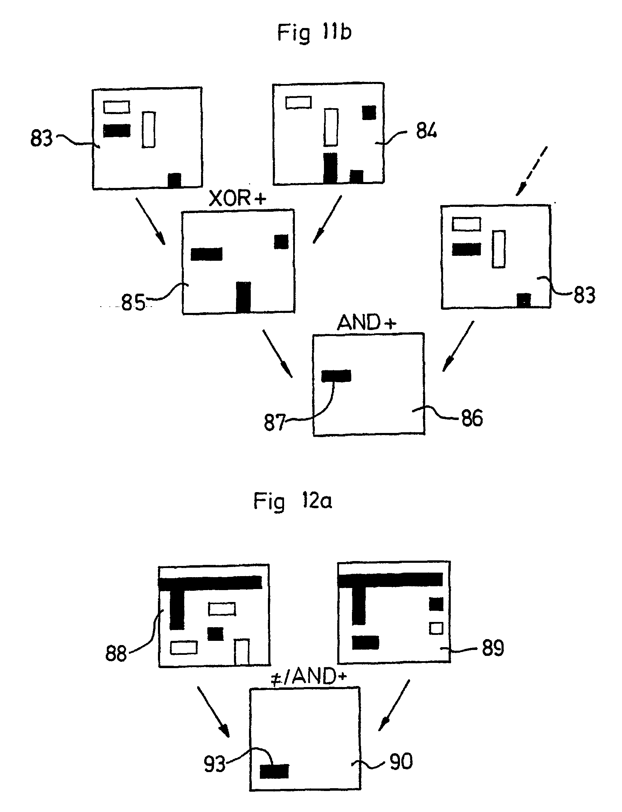

Les figures 12a et 12b représentent une variante de procédé selon l'invention pour la localisation d'une porte logique défaillante sur un circuit dépassivé ou non passivé. Lors de l'étape représentée figure 12a, on effectue la différence entre une image de vecteur normal 88 et une image de vecteur anormal 89, pour obtenir une image d'entrée défaut 90 représentant la ligne équipotentielle 93 d'entrée de la porte logique défaillante. Cette étape peut être similaire à celle représentée figure 10a, et peut être réalisée avec plusieurs images 88 de vecteur normal, combinées ensuite par une intersection étendue AND+ comme dans le cas de la figure 10a. Les images issues de chaque différence subissent un seuillage adaptatif et un traitement de réduction avant d'effectuer l'intersection étendue AND+. L'image de vecteur anormal est de préférence obtenue avec le premier vecteur de localisation anormal, et les images de vecteur normal peuvent être choisies parmi les images obtenues avec les vecteurs de localisation normaux antérieurs. La seule différence qu'il y a entre une image de circuit non passivé et une image de circuit passivé provient du fait que les lignes équipotentielles de connexion aux bornes d'entrée et de sortie sont visibles.

Comme représenté figure 12b, pour localiser la ligne équipotentielle de sortie 92 de la porte logique défaillante, on réalise l'intersection étendue AND+ des images 88 de vecteur normal et 89 de vecteur anormal. Préalablement, ces images sont soumises à un seuillage adaptatif suivi d'un traitement de réduction. L'image 91 obtenue représente donc la ligne équipotentielle de sortie 92 de la porte logique défaillante ainsi que l'équipotentielle de connexion à la borne de sortie. A partir de cette image 91 et de l'image 90 représentant la ligne équipotentielle d'entrée 93, il est aisé de localiser la porte logique défaillante, comme indiqué ci-dessus dans le cas d'un circuit passivé.

Il est à noter que l'invention est tout aussi bien applicable avec d'autres systèmes d'imagerie que les imageries par microscopie électronique en contraste de potentiel par détection des électrons secondaires. En effet, tout système d'imagerie permettant de visualiser par contraste les équipotentielles et fournissant des images sous forme de pixels peut être utilisé.

## Revendications

**1.** Procédé de localisation d'un défaut de type court-circuit, d'une porte logique, dite porte logique défaillante, d'un circuit intégré, dit circuit défaillant, comprenant une puce, des bornes d'entrée et des bornes de sortie reliées les unes aux autres par des pistes électriquement conductrices, et des portes logiques formées au sein de la puce du circuit en forme générale de plaquette définissant un plan principal de la puce, les pistes s'étendant dans l'épaisseur de la puce ou en surface, globalement parallèlement au plan principal, les bornes d'entrée et de sortie étant reliées aux pistes à la périphérie de la puce, et au moins deux bornes d'alimentation en énergie électrique sous tension continue (VDD-VSS), dont au moins une borne d'alimentation est reliée à un potentiel haut VDD et au moins une borne d'alimentation reliée à un potentiel bas VSS, dans lequel :

- on crée et on enregistre une séquence de vecteurs distincts, dits vecteurs de localisation, formés chacun d'un ensemble de signaux adaptés pour pouvoir être appliqués aux différentes bornes d'entrée du circuit défaillant, prenant l'un des états logiques 0 et 1 et conservant cet état logique pendant toute une durée pendant laquelle on considère que le vecteur de localisation est appliqué aux bornes d'entrée, de sorte que cette séquence peut être appliquée pas à pas, un vecteur de localisation après l'autre, et en maintenant chaque vecteur de localisation appliqué pendant une durée aussi longue que nécessaire sur les bornes d'entrée du circuit défaillant et/ou d'un circuit étalon sans que l'état électrique de ce circuit ne change pendant cette durée,

- pour au moins un vecteur de localisation appliqué aux bornes d'entrée du circuit défaillant et d'un circuit intégré, dit circuit étalon, qui est exempt de porte défaillante et de tout défaut, et est identique par ailleurs au circuit défaillant, on réalise et on enregistre un jeu d'images, dites images de vecteur, représentant des lignes équipotentielles formées par les pistes et les portes logiques dudit circuit, chaque ligne équipotentielle correspondant à l'un des états de potentiel différenciés sur les images de vecteur, les différentes images de vecteur d'un même jeu d'images étant adaptées pour couvrir et représenter toute la surface de la puce ou toute une portion de cette surface sur laquelle on cherche à localiser la porte logique défaillante,

- on applique pas à pas la séquence de vecteurs de localisation aux bornes d'entrée du circuit défaillant, et pour chaque vecteur de localisation, on mesure la valeur IDDQ(j) du courant de consommation électrique au repos IDDQ du circuit défaillant circulant dans l'une au moins des bornes d'alimentation, et on détermine si cette valeur mesurée IDDQ(j) est normale ou anormale et on enregistre le résultat de cette détermination,

- on applique au moins un vecteur de localisation, dit vecteur de localisation anormal, aux bornes d'entrée du circuit défaillant et/ou d'un circuit étalon, pour lequel on a préalablement déterminé et enregistré le fait que la valeur mesurée IDDQ(j) du courant de consommation électrique au repos IDDQ du circuit défaillant est anormale, et on réalise et on enregistre un jeu d'images, dites images de vecteur anormal, dudit circuit avec ce vecteur de localisation anormal,

- dans une étape ultérieure de localisation de la porte défaillante, on effectue au moins une comparaison entre au moins une image de vecteur anormal (70, 76, 81, 89) et une autre image préenregistrée, dite image de référence (71, 77, 82, 88), correspondant à une même portion de surface de la puce du circuit défaillant ou du circuit étalon que l'image de vecteur anormal, ces images étant choisies pour que cette comparaison permette de sélectionner une zone, dite zone de défaillance, de la surface de la puce sur laquelle peut être située une ligne équipotentielle d'entrée (73, 93) de la porte logique défaillante et/ou une ligne équipotentielle de sortie (74, 87, 92) de la porte logique défaillante et/ou la porte logique défaillante.

2. Procédé selon la revendication 1, **caractérisé en ce que** :

   - dans une première étape, on crée et on enregistre la séquence de vecteurs de localisation,
   - dans une deuxième étape, on applique pas à pas la séquence de vecteurs de localisation aux bornes d'entrée du circuit défaillant, on mesure la valeur IDDQ(j) du courant de consommation électrique au repos IDDQ du circuit défaillant pour chaque vecteur de localisation, on détermine si le vecteur de localisation est anormal, et on enregistre cette information,
   - dans une troisième étape, on sélectionne et on enregistre parmi la séquence de vecteurs de localisation, une liste de vecteurs de localisation adaptée pour réaliser les images de vecteur permettant, par comparaison, de localiser la porte défaillante,
   - dans une quatrième étape, on applique séquentiellement pas à pas la liste de vecteurs de localisation aux bornes d'entrée du circuit défaillant et/ou d'un circuit étalon, et on réalise et on enregistre un jeu d'images de vecteur pour les vecteurs de localisation de cette liste,
   - dans une cinquième étape, on réalise l'étape de localisation de la porte défaillante en utilisant les images de vecteur réalisées à la quatrième étape.

3. Procédé selon les revendications 1 ou 2, **caractérisé en ce qu'**on crée la séquence de vecteurs de localisation de telle sorte que chaque vecteur de localisation est formé de signaux binaires au format NRZ conservant le même état logique 0 ou 1 jusqu'à ce qu'un vecteur de localisation subséquent soit appliqué aux bornes d'entrée, ou, s'il s'agit du dernier vecteur de localisation, jusqu'à la fin de la(des) mesure(s) et/ou réalisation(s) d'image(s) effectuée(s) pour ce vecteur de localisation.

4. Procédé selon les revendications 1 à 3, **caractérisé en ce qu'**on crée la séquence de vecteurs de localisation à partir d'une séquence de vecteurs, dits vecteurs de test, préalablement formée et enregistrée, et adaptée pour permettre de déterminer l'existence uniquement d'une porte défaillante dans le circuit défaillant par la mesure de la valeur du courant de consommation électrique au repos IDDQ du circuit défaillant, et on décompose chaque vecteur de test pour lequel le signal binaire d'au moins une borne d'entrée est susceptible de changer d'état logique, en une pluralité de vecteurs de localisation dont les signaux binaires ne changent pas d'état logique.

5. Procédé selon l'une des revendications 1 à 4, **caractérisé en ce qu'**on crée la séquence des vecteurs de localisation de sorte que deux vecteurs de localisation consécutifs sont distincts l'un de l'autre par la valeur d'un et un seul signal binaire appliqué à une et une seule borne d'entrée.

6. Procédé selon l'une des revendications 1 à 5, **caractérisé en ce que** pour mesurer la valeur du courant de consommation électrique au repos IDDQ du circuit défaillant, on applique au moins une borne d'alimentation du circuit défaillant, à l'entrée d'un circuit amplificateur (23) monté en convertisseur courant/tension.

7. Procédé selon la revendication 6, **caractérisé en ce qu'**on utilise la borne d'alimentation du circuit défaillant reliée à un potentiel bas VSS, et **en ce que** le circuit amplificateur (23) monté est un convertisseur courant/tension et est adapté pour créer une masse virtuelle ajustable selon les contraintes imposées par l'alimentation du circuit intégré sur lequel on mesure la valeur du courant IDDQ.

8. Procédé selon la revendication 7, **caractérisé en ce qu'**on déterminé si la valeur mesurée IDDQ(j) est normale ou anormale en la comparant à une valeur de courant de consommation électrique au repos nominale IDDQnom connue du circuit défaillant

9. Procédé selon l'une des revendications 1 à 7, **caractérisé en ce qu'**on détermine si la valeur mesurée IDDQ(j) est normale ou anormale en calculant la différence normalisée

   $$D=[IDDQ(j)-IDDQ^0(j)]/\text{maximum}[IDDQ^0(j), \text{Imin}]$$

   où

   IDDQ(j) est la valeur mesurée du courant de consommation électrique au repos IDDQ du circuit défaillant avec le vecteur de test j,

   $IDDQ^0(j)$ est la valeur mesurée du courant de consommation électrique au repos IDDQ d'un circuit étalon,

   Imin est une valeur minimum de courant prédéterminée pour annihiler les effets de bruit, la valeur IDDQ(j) étant considérée comme anormale si D est supérieure à une valeur seuil DS prédéterminée.

10. Procédé selon la revendication 9, **caractérisé en ce qu'**on choisit DS compris entre 2 et 100.

11. Procédé selon l'une des revendications 1 à 10, **caractérisé en ce qu'**après avoir effectué une première comparaison, lors de laquelle au moins une zone de défaillance de la surface de la puce a été sélectionnée, on effectue au moins une comparaison ultérieure uniquement à partir d'images de vecteur correspondant à ladite zone de défaillance.

12. Procédé selon l'une des revendications 1 à 11, **caractérisé en ce que** pour un vecteur de localisation anormal, on effectue une comparaison de deux jeux d'images du circuit défaillant et/ou d'un circuit étalon, l'un au moins des deux jeux d'images étant un jeu d'images de vecteur obtenu avec ledit vecteur de localisation anormal, de façon à sélectionner une zone de défaillance dans laquelle la porte logique défaillante peut être située, et on effectue ensuite une comparaison ultérieure uniquement avec les jeux d'images de vecteur représentant ladite zone de défaillance.

13. Procédé selon les revendications 1 à 12, **caractérisé en ce que** lors d'une première comparaison de l'étape de localisation du défaut, on utilise à titre d'image de vecteur anormal, au moins une image de vecteur d'un jeu d'images de vecteurs obtenue avec le premier vecteur de localisation anormal, apparaissant en premier dans la séquence de vecteurs de localisation.

14. Procédé selon les revendications 1 à 13, **caractérisé en ce qu'**on teste la fonctionnalité électrique du circuit défaillant, et, dans le cas où le circuit défaillant s'avère être non fonctionnel pour au moins une borne de sortie, on utilise, à titre d'image de référence, une image de vecteur, dite image de référence défaut (71), obtenue avec le circuit défaillant pour un vecteur de localisation, dit vecteur de localisation normal, pour lequel la valeur mesurée du courant de consommation au repos IDDQ du circuit défaillant est normale.

15. Procédé selon les revendications 13 et 14, **caractérisé en ce qu'**on utilise, à titre d'image de référence défaut (71), une image de vecteur obtenue avec le circuit défaillant, lors de la même séquence de vecteurs de localisation, avec un vecteur de localisation antérieur au vecteur de localisation anormal.

16. Procédé selon les revendications 14 et 15, **carac-**

**térisé en ce que** pour une comparaison, on utilise à titre d'image de vecteur anormal, une image de vecteur, dite image de vecteur anormal défaut (70) du circuit défaillant, et **en ce que** pour comparer l'image de vecteur anormal défaut (70) et l'image de référence défaut (71), on forme une image, dite image d'entrée défaut simple (72, 72') représentant les lignes équipotentielles du circuit défaillant qui sont de même forme, de même emplacement, et d'états de potentiel différents entre l'image de vecteur anormal défaut (70) et l'image de référence défaut (71), de façon à être représentative de la ligne équipotentielle d'entrée de la porte logique défaillante.

17. Procédé selon la revendication 16, **caractérisé en ce qu'**on forme plusieurs images d'entrée défaut simples (72, 72') à partir d'une même image de vecteur anormal défaut (70) que l'on compare à plusieurs images de référence défaut (71), et **en ce qu'**on forme une image, dite image d'entrée défaut intersection (75), représentant les ligues équipotentielles communes entre les différentes images d'entrée défaut simples (72, 72').

18. Procédé selon l'une des revendications 14 à 17, **caractérisé en ce que** lors de l'étape de localisation de la porte défaillante, on effectue au moins une comparaison entre deux images d'un circuit étalon formées d'une image de vecteur anormal, dite image de vecteur anormal étalon (76), obtenue en appliquant à ce circuit étalon un vecteur de localisation anormal, et d'une image de référence, dite image de référence étalon (77), obtenue en appliquant au circuit étalon un vecteur de localisation normal.

19. Procédé selon la revendication 18, **caractérisé en ce qu'**à partir de l'image de vecteur anormal étalon (76) et de l'image de référence étalon (77), on forme une image, dite image d'entrée/sortie étalon simple (78, 78'), représentant les lignes équipotentielles du circuit étalon qui sont de même forme, de même emplacement, et d'états de potentiel différents entre l'image de vecteur anormal étalon (76) et l'image de référence étalon (77), de façon à être représentative de la ligne équipotentielle d'entrée et de la ligne équipotentielle de sortie de la porte logique défaillante du circuit défaillant.

20. Procédé selon la revendication 19, **caractérisé en ce qu'**on forme plusieurs images d'entrée/sortie étalon simples (78, 78') à partir d'une même image de vecteur anormal étalon (76) que l'on compare à plusieurs images de référence étalon (77), et **en ce qu'**on forme une image, dite image d'entrée/sortie étalon intersection (79), représentant les lignes équipotentielles communes entre les différentes images d'entrée/sortie étalon simples (78, 78').

**21.** Procédé selon l'une des revendications 16 ou 17 et l'une des revendications 19 ou 20, **caractérisé en ce que** lors d'une comparaison ultérieure, on forme une image, dite image de sortie (80), représentant les lignes équipotentielles apparaissant sur une image d'entrée défaut simple (72, 72') ou intersection (75) ou sur une image d'entrée/sortie étalon simple (78, 78') ou intersection (79); à l'exclusion des lignes équipotentielles communes entre ces images, cette image de sortie (80) représentant la ligne équipotentielle de sortie de la porte logique défaillante et sa propagation dans le circuit défaillant.

**22.** Procédé selon la revendication 21, **caractérisé en ce qu'**on divise une image entrée défaut simple (72, 72') ou intersection (75) et une image de sortie (80) représentant la même portion de surface de la puce en fenêtres rectangulaires jointives de mêmes dimensions fixes prédéterminées plus petites que celles de ces images (72, 72', 75, 80), on examine pour chaque fenêtre si chacune des deux images (72, 72', 75, 80) présente ou non au moins une ligne équipotentielle, et on sélectionne et on enregistre la(les) fenêtre(s) présentant au moins une ligne équipotentielle dans chacune de ces deux images (72, 72', 75, 80).

**23.** Procédé selon l'une des revendications 1 à 13, **caractérisé en ce qu'**on teste la fonctionnalité électrique du circuit défaillant et, dans le cas où le circuit défaillant s'avère être fonctionnel pour toutes les bornes de sortie, on effectue une comparaison entre au moins une première image de vecteur anormal (81) obtenue avec un premier vecteur de localisation anormal et au moins une deuxième image de vecteur anormal (82) obtenue avec le même circuit et avec un deuxième vecteur de localisation anormal distinct du premier vecteur de localisation anormal, les premier et deuxième vecteurs de localisation anormaux appartenant à la même séquence de vecteurs de localisation.

**24.** Procédé selon la revendication 23, **caractérisé en ce qu'**on forme une image, dite image de sortie défaut (83), représentant la(les) lignes équipotentielle(s) qui est(sont) commune(s) aux différentes images de vecteur anormal (81, 82), comprenant la ligne équipotentielle de sortie (87) de la porte logique défaillante.

**25.** Procédé selon la revendication 24, **caractérisé en ce que** lors d'une comparaison ultérieure, on forme une image, dite image de sortie intermédiaire (85), représentant les lignes équipotentielles apparaissant en commun sur l'image de sortie défaut (83) et sur au moins une image de vecteur normal (84) obtenue avec un vecteur de localisation normal, à l'exclusion des lignes équipotentielles communes entre cette image de sortie défaut (83) et cette image de vecteur normal (84), ladite image de sortie intermédiaire (85) comprenant la ligne équipotentielle de sortie (87) de la porte logique défaillante.

**26.** Procédé selon les revendications 24 et 25, **caractérisé en ce que** lors d'une comparaison ultérieure, on forme une image, dite image de sortie (86), représentant les lignes équipotentielles communes à l'image de sortie défaut (83) et à l'image de sortie intermédiaire (85), ladite image de sortie (86) représentant la ligne équipotentielle de sortie de la porte logique défaillante.

**27.** Procédé selon l'une des revendications 1 à 26, **caractérisé en ce qu'**on réalise les images de test par microscopie électronique à balayage en contraste de potentiel par détection des électrons secondaires.

**28.** Procédé selon l'une des revendications 1 à 27, **caractérisé en ce qu'**on enregistre les images de vecteur sous forme pixelisée, monochromes, et on effectue chaque comparaison entre images sous forme pixelisée, par voie numérique pixel par pixel.

**29.** Procédé selon la revendication 28, **caractérisé en ce qu'**avant d'utiliser une image dans une étape de comparaison d'images, on réalise préalablement une intégration de cette image sur plusieurs clichés identiques correspondant à cette image, et un filtrage médian en affectant à chaque pixel la valeur médiane de l'ensemble de pixels comprenant ce pixel et les pixels qui l'entourent, de façon à supprimer les pics dus au bruit.

**30.** Procédé selon l'une des revendications 28 ou 29, **caractérisé en ce que** pour former une image représentant les lignes équipotentielles qui sont de même forme, de même emplacement, et d'états de potentiel différents entre deux images de départ, on réalise, pixel par pixel, une différence des deux images de départ selon la formule :

$$PC = (PA-PB)/2 + INT(E/2)$$

où PA est la valeur de niveau de contraste du pixel de la première image d'entrée ; PB est la valeur de niveau de contraste du pixel de la deuxième image d'entrée ; E est la valeur maximum de niveau de contraste des images ; PC est la valeur de niveau de contraste du pixel de l'image formée ; INT est la fonction partie entière.

**31.** Procédé selon l'une des revendications 28 à 30, **caractérisé en ce que** pour former une image représentant les lignes équipotentielles communes entre deux images de départ, on réalise :

- une étape de seuillage adaptatif à trois niveaux de niveaux de contraste blanc, noir, gris,
- pixel par pixel, une intersection étendue AND+ lors de laquelle on affecte à chaque pixel de l'image à former, les niveaux de contraste suivants :

  . noir si les deux pixels des images de départ sont noires à l'issue du seuillage adaptatif,
  . blanc si les deux pixels des images de départ sont blancs à l'issue du seuillage adaptatif,
  . gris dans tous les autres cas.

32. Procédé selon l'une des revendications 28 à 31, **caractérisé en ce que** pour former une image représentant les lignes équipotentielles de l'une ou l'autre de deux images de départ, à l'exclusion des lignes équipotentielles communes à ces deux images de départ, on réalise:

- une étape de seuillage adaptatif à trois niveaux de contraste blanc, noir, gris.
- pixel par pixel, une comparaison par OU exclusif étendu XOR+ lors de laquelle on affecte à chaque pixel de l'image à former, les niveaux de contraste suivants :

  . gris si les deux pixels des images de départ ont le même niveau de contraste à l'issue du seuillage adaptatif,
  . blanc si les deux pixels des images de départ sont blanc et gris ; ou blanc et noir ; ou gris et noir à l'issue du seuillage adaptatif,
  . noir si les deux pixels des images de départ sont noir et gris ; ou noir et blanc ; ou gris et blanc.

33. Installation de localisation d'un défaut de type court-circuit, d'une porte logique, dite porte logique défaillante, d'un circuit intégré, dit circuit défaillant, comprenant une puce des bornes d'entrée et des bornes de sortie reliées les unes aux autres par des pistes électriquement conductrices et des portes logiques formées au sein de la puce du circuit en forme générale de plaquette définissant un plan principal de la puce, les pistes s'étendant dans l'épaisseur de la puce ou en surface, globalement parallèlement au plan principal, les bornes d'entrée et de sortie étant reliées aux pistes à la périphérie de la puce, et au moins deux bornes d'alimentation en énergie électrique sous tension continue (VDD-VSS), dont au moins une borne d'alimentation est reliée à un potentiel haut VDD et au moins une borne d'alimentation reliée à un potentiel bas VSS, ladite installation comprenant :

- des moyens (10) pour créer et enregistrer une séquence de vecteurs distincts, dits vecteurs de localisation, formés chacun d'un ensemble de signaux binaires adaptés pour pouvoir être appliqués aux différentes bornes d'entrée du circuit défaillant, prenant l'un des états logiques 0 et 1 et conservant cet état logique pendant toute une durée pendant laquelle le vecteur de localisation est considéré comme étant appliqué aux bornes d'entrée,
- des moyens (1) d'imagerie d'équipotentielles aptes à réaliser et à enregistrer, pour au moins un vecteur de localisation appliqué aux bornes d'entrée du circuit défaillant et d'un circuit intégré, dit circuit étalon, exempt de porte défaillante et de tout défaut, et identique par ailleurs au circuit défaillant, un jeu d'images, dites images de vecteur, représentant des lignes équipotentielles formées par les pistes et les portes logiques dudit circuit, chaque ligne équipotentielle correspondant à l'un des états de potentiel différenciés sur les images de vecteur, les différentes images de vecteur d'un même jeu d'images étant adaptées pour couvrir et représenter toute la surface de la puce ou toute une portion de cette surface sur laquelle on cherche à localiser la porte logique défaillante,
- des moyens (11, 12) pour appliquer pas à pas la séquence de vecteurs de localisation aux bornes d'entrée du circuit défaillant,
- des moyens (23) de mesure pour chaque vecteur de localisation, de la valeur IDDQ(j) du courant de consommation électrique au repos IDDQ du circuit défaillant circulant dans l'une au moins des bornes d'alimentation,
- des moyens (11) de calcul aptes à déterminer si cette valeur mesurée IDDQ(j) est normale ou anormale et à enregistrer le résultat de cette détermination,
- des moyens (6) de calcul aptes à effectuer au moins une comparaison entre au moins une image de vecteur anormal (70, 76, 81, 89) et une autre image préenregistrée, dite image de référence (71, 77, 82, 88), correspondant à une même portion de surface de la puce du circuit défaillant ou du circuit étalon que l'image de vecteur anormal, ces images étant choisies pour que cette comparaison permette de sélectionner une zone, dite zone de défaillance, de la surface de la puce sur laquelle peut être située une ligne équipotentielle d'entrée (73) de la porte logique défaillante et/ou une ligne équipotentielle de sortie (74) de la porte logique défaillante et/ou la porte logique défaillante.

34. Installation selon la revendication 33, **caractérisée**

**en ce que** les moyens (23) de mesure de la valeur du courant de consommation électrique au repos IDDQ du circuit, comprennent un circuit (23) amplificateur monté en convertisseur courant/tension.

35. Installation selon la revendication 34, **caractérisée en ce que** le circuit (23) amplificateur monté en convertisseur courant/tension est adapté pour créer une masse virtuelle ajustable selon les contraintes imposées par l'alimentation du circuit intégré.

**Claims**

1. A method for location of a fault of the short-circuit type, of a logic gate, known as the defective logic gate, of an integrated circuit, known as the defective circuit, comprising a chip, input terminals and output terminals connected to one another by electrically conductive tracks, and logic gates formed within the chip of the circuit, which is generally in the form of a wafer which defines a main plane of the chip, the tracks extending in the thickness of the chip or on the surface, globally parallel to the main plane, the input and output terminals being connected to the tracks at the periphery of the chip, and at least two electrical energy supply terminals with direct voltage (VDD-VSS), at least one supply terminal of which is connected to a high potential VDD, and at least one supply terminal of which is connected to a low potential VSS, in which:

   - there is creation and recording of a sequence of distinct vectors, known as location vectors, each of which is formed from a series of signals, which are designed to be able to be applied to the different input terminals of the defective circuit, assuming one of the logic states 0 and 1, and maintaining this logic state throughout an entire period in which it is considered that the location vector is applied to the input terminals, such that this sequence can be applied step by step, one location vector after the other, and keeping each location vector applied for a period which is as long as necessary on the input terminals of the defective circuit and/or of a standard circuit, without the electric state of this circuit changing during this duration;
   - for at least one location vector applied to the input terminals of the defective circuit and of an integrated circuit, known as the standard circuit, which is free from a defective gate and from any fault, and is also identical to the defective circuit, a set of images, known as vector images, is produced and recorded, representing equipotential lines formed by the tracks and the logic gates of the said circuit, each equipotential line corresponding to one of the differentiated states of potential on the vector images, the different vector images of a single set of images being designed to cover and represent the entire surface of the chip, or an entire portion of this surface on which it is being attempted to locate the defective logic gate;
   - the sequence of location vectors is applied step by step to the input terminals of the defective circuit, and for each location vector, measurement is made of the value IDDQ(j) of the electrical consumption current at rest IDDQ of the defective circuit, which is circulating in at least one of the supply terminals, and it is determined whether this value measured IDDQ(j) is normal or abnormal, and the result of this determination is recorded;
   - at least one location vector, known as the abnormal location vector, is applied to the input terminals of the defective circuit and/or of a standard circuit, for which the fact has previously been determined and recorded that the value measured IDDQ(j) of the electrical consumption current at rest IDDQ of the defective circuit is abnormal, and a set of images, known as abnormal vector images, of the said circuit with this abnormal location vector is produced and recorded; and
   - in a further step of location of the defective gate, at least one comparison is made between at least one abnormal vector image (70, 76, 81, 89) and another pre-recorded image, known as the reference image (71, 77, 82, 88), corresponding to the same portion of surface of the chip of the defective circuit or of the standard circuit as the abnormal vector image, these images being selected such that this comparison makes it possible to select an area, known as the defective area, of the surface of the chip on which there can be located an equipotential input line (73, 93) of the defective logic gate and/or an equipotential output line (74, 87, 92) of the defective logic gate, and/or the defective logic gate.

2. A method as claimed in claim 1, **characterized in that**:

   - in a first step, the sequence of location vectors is created and recorded;
   - in a second step, there is application step by step of the sequence of location vectors, to the input terminals of the defective circuit, the value IDDQ(j) is measured of the electrical consumption current at rest IDDQ of the defective circuit, for each location vector, it is determined whether the location vector is abnormal, and this information is recorded;
   - in a third step, there is selection and recording from amongst the sequence of location vectors, of a list of location vectors which is designed to produce the vector images which make it possible to locate the defective gate by comparison;

- in a fourth step, there is application, sequentially, step by step, of the list of location vectors, to the input terminals of the defective circuit and/or of a standard circuit, and a set of vector images for the location vectors of this list is produced and recorded; and

- in a fifth step, the step of location of the defective gate is carried out by using the vector images produced in the fourth step.

3. A method as claimed in claim 1 or claim 2, **characterized in that** the sequence of location vectors is created such that each location vector is formed by binary signals with the format NRZ, which maintain the same logic state 0 or 1, until a subsequent location vector is applied to the input terminals, or, if the final location vector is involved, until completion of the measurement(s) and production of image(s) carried out for this location vector.

4. A method as claimed in claims 1 to 3, **characterized in that** the sequence of location vectors is created from a sequence of vectors, known as test vectors, which is previously formed and recorded, and is designed to make it possible to determine the existence only of a defective gate in the defective circuit, by measurement of the value of the electrical consumption current at rest IDDQ of the defective circuit, and each test vector for which the binary signal of at least one input terminal is liable to change its logic state, is broken down into a plurality of location vectors, the logic state of the binary signals of which does not change.

5. A method as claimed in any one of claims 1 to 4, **characterized in that** the sequence of location vectors is created such that two consecutive location vectors are distinguished from one another by the value of a single binary signal applied to a single input terminal.

6. A method as claimed in any one of claims 1 to 5, **characterized in that**, in order to measure the value of the electrical consumption current at rest IDDQ of the defective circuit, at least one supply terminal of the defective circuit is applied to the input of an amplifier circuit (23) which is fitted as a current/voltage converter.

7. A method as claimed in claim 6, **characterized in that** the supply terminal of the defective circuit which is connected to a low potential VSS is used, and the amplifier circuit (23) fitted is a current/voltage converter, and is designed to create a virtual memory, which is adjustable according to the constraints imposed by the supply of the integrated circuit on which the value of the current IDDQ is measured.

8. A method as claimed in claim 7, **characterized in that** it is determined whether the value measured IDDQ(j) is normal or abnormal, by comparing it with a known nominal electrical consumption current at rest IDDQnom of the defective circuit.

9. A method as claimed in any one of claims 1 to 7, **characterized in that** it is determined whether the value measured IDDQ(j) is normal or abnormal, by calculating the standardised difference:

$$D=[IDDQ(j)-IDDQ^0(j)]/maximum[IDDQ^0(j),Imin]$$

in which
IDDQ(j) is the value measured of the electrical consumption current at rest IDDQ, of the defective circuit with the test vector j;
$IDDQ^0(j)$ is the value measured of the electrical consumption current at rest IDDQ, of a standard circuit; and
Imin is a minimum current value which is pre-determined in order to eliminate the effects of noise, the value IDDQ(j) being considered to be abnormal if D is greater than a pre-determined threshold value DS.

10. A method as claimed in claim 9, **characterized in that** DS is selected between 2 and 100.

11. A method as claimed in any one of claims 1 to 10, **characterized in that**, after a first comparison has been made, in which at least one defective area of the surface of the chip has been selected, at least one further comparison is made, only from vector images which correspond to the said defective area.

12. A method as claimed in any one of claims 1 to 11, **characterized in that**, for an abnormal location vector, a comparison is made of two sets of images of the defective circuit and/or of a standard circuit, at least one of the two sets of images being a set of vector images which is obtained with the said abnormal location vector, such as to select a defective area in which the defective logic gate can be located, and a further comparison is subsequently made only with the sets of vector images which represent the said defective area.

13. A method as claimed in any one of claims 1 to 12, **characterized in that**, during a first comparison of the step of location of the fault, the abnormal vector image used for the image is at least one vector image of a set of vector images, obtained with the first abnormal location vector appearing first in the sequence of location vectors.

14. A method as claimed in any one of claims 1 to 13, **characterized in that** the electrical functionality of the defective circuit is tested, and, if the defective circuit is found to be non-functional as far as one output terminal at least is concerned, as the reference image, use is made of a vector image, known as the fault reference image (71), obtained with the defective circuit for a location vector, known as the normal location vector, for which the value measured of the consumption current at rest IDDQ of the defective circuit, is normal.

15. A method as claimed in claim 13 and claim 14, **characterized in that** the fault reference image (71) used is a vector image which is obtained with the defective circuit, in the same sequence of location vectors, with a location vector which precedes the abnormal location vector.

16. A method as claimed in claim 14 and claim 15, **characterized in that**, for a comparison, the abnormal vector image used is a vector image, known as the fault abnormal vector image (70), of the defective circuit, and, in order to compare the fault abnormal vector image (70) and the fault reference image (71), an image is formed, known as the simple fault input image (72, 72'), representing the equipotential lines of the defective circuit which have the same form and the same location, and states of potential which differ between the fault abnormal vector image (70) and the fault reference image (71), such as to be representative of the equipotential input line of the defective logic gate.

17. A method as claimed in claim 16, **characterized in that** a plurality of simple fault input images (72, 72') is formed from a single fault abnormal vector image (70), which is compared with a plurality of fault reference images (71), and an image is formed, known as the intersection fault input image (75), representing the equipotential lines which are common amongst the different simple fault input images (72, 72').

18. A method as claimed in any one of claims 14 to 17, **characterized in that**, during the step of location of the defective gate, at least one comparison is made between two images of a standard circuit formed from an abnormal vector image, known as the standard abnormal vector image (76), obtained by applying an abnormal location vector to this standard circuit, and from a reference image, known as the standard reference image (77), obtained by applying a normal location vector to the standard circuit.

19. A method as claimed in claim 18, **characterized in that**, on the basis of the standard abnormal vector image (76) and the standard reference image (77), an image is formed, known as the simple standard input/output image (78, 78'), representing the equipotential lines of the standard circuit which have the same form and the same location, and states of potential which differ between the standard abnormal vector image (76) and the standard reference image (77), such as to be representative of the equipotential input line and the equipotential output line of the defective logic gate of the defective circuit.

20. A method as claimed in claim 19, **characterized in that** a plurality of simple standard input/output images (78, 78') is formed from a single standard abnormal vector image (76), which is compared with a plurality of standard reference images (77), and an image is formed, known as the intersection standard input/output image (79), representing the equipotential lines which are common amongst the different simple standard input/output images (78, 78').

21. A method as claimed in claim 16 or claim 17, and claim 19 or claim 20, **characterized in that**, during a further comparison, an image is formed, known as the output image (80), representing the equipotential lines which appear on a simple fault input image (72, 72') or on an intersection fault input image (75), or on a simple standard input/output image (78, 78'), or on an intersection standard input/output image (79); with the exclusion of the equipotential lines which are common amongst these images, this output image (80) representing the equipotential output line of the defective logic gate, and its propagation in the defective circuit.

22. A method as claimed in claim 21, **characterized in that** there is division of an intersection (75) or simple (72, 72') fault input image and an output image (80) representing the same portion of surface of the chip, in adjacent rectangular windows which have the same pre-determined fixed dimensions, which are smaller than those of these images (72, 72', 75, 80), for each window it is examined whether each of the two images (72, 72', 75, 80) does or does not have at least one equipotential line, and the window (s) having at least one equipotential line in each of these two images (72, 72', 75, 80) is/are selected and recorded.

23. A method as claimed in any one of claims 1 to 13, **characterized in that** the electrical functionality of the defective circuit is tested, and, if the defective circuit is found to be functional for all the output terminals, a comparison is made between at least one first abnormal vector image (81) obtained with a first abnormal location vector, and at least one second abnormal vector image (82) obtained with the same circuit, and with a second abnormal location vector which is distinct from the first abnormal location vector, the first and second abnormal location vectors belonging to the same sequence of location vectors.

24. A method as claimed in claim 23, **characterized in that** an image is formed, known as the fault output image (83), representing the equipotential line(s) which is/are common to the different abnormal vector images (81, 82), comprising the equipotential output line (87) of the defective logic gate.

25. A method as claimed in claim 24, **characterized in that**, in a further comparison, an image is formed, known as the intermediate output image (85), representing the equipotential lines which appear in common on the fault output image (83) and on at least one normal vector image (84) obtained with a normal location vector, with the exclusion of the equipotential lines which are common to this fault output image (83) and this normal vector image (84), the said intermediate output image (85) comprising the equipotential output line (87) of the defective logic gate.

26. A method as claimed in claim 24 and claim 25, **characterized in that**, in a further comparison, an image is formed, known as the output image (86), which represents the equipotential lines common to the fault output image (83) and to the intermediate output image (85), the said output image (86) representing the equipotential output line of the defective logic gate.

27. A method as claimed in any one of claims 1 to 26, **characterized in that** the test images are produced by electronic scanning microscopy with contrast of potential, by detection of the secondary electrons.

28. A method as claimed in any one of claims 1 to 27, **characterized in that** the vector images are recorded in monochrome pixelised form, and each comparison is made between images in pixelised form, numerically, pixel by pixel.

29. A method as claimed in claim 28, **characterized in that**, before using an image in an image comparison step, this image is previously integrated onto a plurality of identical exposures which correspond to this image, and median filtering is carried out by allocating to each pixel the median value of the series of pixels comprising this pixel and the pixels which surround it, such as to eliminate the peaks caused by the noise.

30. A method as claimed in claim 28 or claim 29, **characterized in that**, in order to form an image representing the equipotential lines which have the same form and the same location, and states of potential which differ between two initial images, a difference in the two initial images is produced pixel by-pixel, according to the formula:

$$PC=(PA-PB)/2+INT(E/2)$$

in which PA is the value of the contrast level of the pixel of the first input image; PB is the value of the contrast level of the pixel of the second input image; E is the maximum value of the contrast level of the images; PC is the value of the contrast level of the pixel of the image formed; and INT is the whole part function.

31. A method as claimed in any one of claims 28 to 30, **characterized in that**, in order to form an image representing the common equipotential lines which are common to two initial images, there are carried out:

- a thresholding step, which adapts to three contrast levels , i.e. white, black and grey; and
- pixel by pixel, an extended AND+ intersection, during which the following contrast levels are allocated to each pixel of the image to be formed:

  . black, if the two pixels of the initial images are black on completion of the adaptive thresholding;
  . white, if the two pixels of the initial images are white on completion of the adaptive thresholding; and
  . grey in all the other cases.

32. A method as claimed in any one of claims 28 to 31, **characterized in that**, in order to form an image which represents the equipotential lines of one or the other of two initial images, with the exclusion of the equipotential lines which are common to these two initial images, there are carried out:

- a thresholding step, which adapts to three contrast levels, i.e. white, black and grey; and
- pixel by pixel, an extended exclusive OR comparison, XOR+, during which the following contrast levels are allocated to each pixel of the image to be formed:

- grey, if the two pixels of the initial images have the same contrast value on completion of the adaptive thresholding;

- white, if the two pixels of the initial images are white and grey; or white and black; or grey and black, on completion of the adaptive thresholding; and

- black, if the two pixels of the initial images are black and grey; or black and white; or grey and white.

33. An installation for location of a fault of the short-circuit type, in a logic gate, known as the defective logic gate, of an integrated circuit, known as the defective circuit, comprising a chip for the input terminals and output terminals, which are connected to one another by electrically conductive tracks and logic gates formed within the chip of the circuit, which is generally in the form of a wafer defining a main plane of the chip, the tracks extending in the thickness of the chip or on the surface, globally parallel to the main plane, the input and output terminals being connected to the tracks at the periphery of the chip, and at least two electrical energy supply terminals with direct voltage (VDD-VSS), at least one supply terminal of which is connected to a high potential VDD, and at least one supply terminal of which is connected to a low potential VSS, the said installation comprising:

- means (10) for creating and recording a sequence of distinct vectors, known as location vectors, each of which is formed from a series of binary signals, which are designed to be able to be applied to the different input terminals of the defective circuit, assuming one of the logic states 0 and 1, and maintaining this logic state throughout an entire period, in which it is considered that the location vector is applied to the input terminals;

- equipotential imagery means (1), which, for at least one location vector applied to the input terminals of the defective circuit and of an integrated circuit, known as the standard circuit, which is free from a defective gate and from any fault, and is also identical to the defective circuit, can produce and record a set of images, known as vector images, representing equipotential lines formed by the tracks and the logic gates of the said circuit, each equipotential line corresponding to one of the differentiated states of potential on the vector images, the different vector images of a single set of images being designed to cover and represent the entire surface of the chip, or an entire portion of this surface on which it is being attempted to locate the defective logic gate,

- means (11, 12) for applying the sequence of location vectors step by step to the input terminals of the defective circuit;

- for each location vector, means (23) for measurement of the value IDDQ(j) of the electrical consumption current at rest IDDQ of the defective circuit, which is circulating in at least one of the supply terminals;

- means (11) for calculation which can determine whether this value measured IDDQ(j) is normal or abnormal, and can record the result of this determination; and

- means (6) for calculation, which can make at least one comparison between at least one abnormal vector image (70, 76, 81, 89) and another pre-recorded image, known as the reference image (71, 77, 82, 88), corresponding to the same portion of surface of the chip of the defective circuit or of the standard circuit as the abnormal vector image, these images being selected such that this comparison makes it possible to select an area, known as the defective area, of the surface of the chip on which there can be located an equipotential input line (73) of the defective logic gate and/or an equipotential output line (74) of the defective logic gate, and/or the defective logic gate.

34. An installation as claimed in claim 33, **characterized in that** the means (23) for measurement of the value of the electrical consumption current at rest IDDQ of the circuit comprise an amplifier circuit (23) which is fitted as a current/voltage converter.

35. An installation as claimed in claim 34, **characterized in that** the amplifier circuit (23) fitted as a current/voltage converter is designed to create a virtual memory, which is adjustable according to the constraints imposed by the supply of the integrated circuit.

**Patentansprüche**

1. Verfahren zum Erkennen eines kurzschlussartigen Fehlers eines Logikports, gestörter Logikport genannt, einer integrierten Schaltung, gestörte Schaltung genannt, umfassend einen Chip, Eingangsanschlüsse und Ausgangsanschlüsse, die miteinander durch elektrische Leiterbahnen verbunden sind, und Logikports, die im Inneren des Chips der Schaltung in der allgemeinen Form eines Wafers ausgebildet sind, der eine Hauptebene des Chips definiert, wobei die Bahnen in der Dicke des Chips oder in der Oberfläche global parallel zur Hauptebene verlaufen, wobei die Ein- und Ausgangsanschlüsse auf der Peripherie des Chips mit den Bahnen verbunden sind, und wenigstens zwei Gleichspannungsversorgungsanschlüsse (VDD-VSS), von denen wenigstens ein Versorgungsanschluss mit einem hohen Potential VDD und wenigstens ein Versorgungsanschluss mit einem niedrigen Potential VSS verbunden ist, umfassend die folgenden Schritte:

-   Erzeugen und Speichern einer Sequenz von unterschiedlichen Vektoren, Erkennungsvektoren genannt, die jeweils aus einem Satz von Signalen gebildet sind, die an verschiedene Eingangsanschlüsse der gestörten Schaltung angelegt werden können und den Logikzustand 0 oder 1 haben können und diesen Logikzustand für die gesamte Dauer behalten, während der der Erkennungsvektor auf die Eingangsanschlüsse angewendet wird, so dass diese Sequenz Schritt für Schritt, ein Erkennungsvektor nach dem anderen, angewendet werden kann, und wobei jeder Erkennungsvektor so lang wie notwendig auf die Eingangsanschlüsse der gestörten Schaltung und/oder einer Kalibrierschaltung angewendet wird, ohne dass sich der elektrische Zustand dieser Schaltung während dieser Dauer ändert,

-   Realisieren und Speichern eines Satzes von Bildern, Vektorbilder genannt, für wenigstens einen Erkennungsvektor, der auf die Eingangsanschlüsse der gestörten Schaltung und einer integrierten Schaltung, Kalibrierschaltung genannt, angewendet wird, die keinen gestörten Port und keinen Fehler hat, aber ansonsten mit der gestörten Schaltung identisch ist, wobei der Bildersatz äquipotentielle Leitungen repräsentiert, die durch die Bahnen und die Logikports der genannten Schaltung gebildet werden, wobei jede äquipotentielle Leitung einem der auf den Vektorbildern differenzierten Potentialzustände entspricht, wobei die unterschiedlichen Vektorbilder desselben Bildersatzes so gestaltet sind, dass sie die gesamte Oberfläche des Chips oder einen gesamten Abschnitt dieser Oberfläche bedecken, auf der der gestörte Logikport erkannt werden soll,

-   schrittweises Anwenden der Erkennungsvektorsequenz auf die Eingangsanschlüsse der gestörten Schaltung, und für jeden Erkennungsvektor Messen des IDDQ(j)-Wertes der Stromaufnahme im Ruhezustand IDDQ der gestörten Schaltung an wenigstens einem der Versorgungsanschlüsse, und Ermitteln, ob dieser gemessene IDDQ(j)-Wert normal oder anormal ist, und Speichern des Ergebnisses dieser Ermittlung,

-   Anwenden von wenigstens einem Erkennungsvektor, anormaler Erkennungsvektor genannt, auf die Eingangsanschlüsse der gestörten Schaltung und/oder einer Kalibrierschaltung, für die zuvor die Tatsache ermittelt und gespeichert wurde, dass der gemessene IDDQ(j)-Wert der Stromaufnahme im Ruhezustand IDDQ der gestörten Schaltung anormal ist, und Realisieren und Speichern eines Satzes von Bildern, anormale Vektorbilder genannt, der genannten Schaltung mit diesem anormalen Erkennungsvektor,

-   in einer späteren Erkennungsstufe des gestörten Ports Durchführen von wenigstens einem Vergleich zwischen wenigstens einem anormalen Vektorbild (70, 76, 81, 89) und einem anderen vorgespeicherten Bild, Referenzbild (71, 77, 82, 88) genannt, das demselben Oberflächenabschnitt des Chips der gestörten Schaltung oder der Kalibrierschaltung entspricht wie das anormale Vektorbild, wobei diese Bilder so gewählt werden, dass es dieser Vergleich zulässt, eine Zone, Störungszone genannt, der Oberfläche des Chips zu wählen, auf der sich eine äquipotentielle Eingangsleitung (73, 93) des gestörten Logikports und/oder eine äquipotentielle Ausgangsleitung (74, 87, 92) des gestörten Logikports und/oder der gestörte Logikport befindet/befinden.

2.  Verfahren nach Anspruch 1, **dadurch gekennzeichnet, dass**:

    -   in einer ersten Stufe die Erkennungsvektorsequenz erzeugt und gespeichert wird,
    -   in einer zweiten Stufe Schritt für Schritt die Erkennungsvektorsequenz an die Eingangsanschlüsse der gestörten Schaltung angewendet wird, der IDDQ(j)-Wert der Stromaufnahme im Ruhezustand IDDQ der gestörten Schaltung für jeden Erkennungsvektor gemessen wird, ermittelt wird, ob der Erkennungsvektor anormal ist, und diese Information gespeichert wird,
    -   in einer dritten Stufe aus der Erkennungsvektorsequenz eine Liste von Erkennungsvektoren ausgewählt und gespeichert wird, die so gestaltet ist, dass sie die Vektorbilder realisiert, mit denen durch Vergleich der gestörte Port gefunden werden kann,
    -   in einer vierten Stufe sequentiell Schritt für Schritt die Liste von Erkennungsvektoren an die Eingangsanschlüsse der gestörten Schaltung und/oder einer Kalibrierschaltung angewendet wird und ein Satz Vektorbilder für die Erkennungsvektoren dieser Liste erzeugt und gespeichert wird,
    -   in einer fünften Stufe die Stufe des Erkennens des gestörten Ports anhand der in der vierten Stufe realisierten Vektorbilder durchgeführt wird.

3.  Verfahren nach Anspruch 1 oder 2, **dadurch gekennzeichnet, dass** die Erkennungsvektorsequenz so erzeugt wird, dass jeder Erkennungsvektor aus binären Signalen im NRZ-Format gebildet wird, die denselben logischen Zustand 0 oder 1 behalten, bis ein nachfolgender Erkennungsvektor auf die Eingangsanschlüsse angewendet wird oder, wenn es sich um den letzten Erkennungsvektor handelt, bis zum Ende des Messens und/oder Realisierens des Bildes/ von Bildern, die für diesen Erkennungsvektor erzeugt wurden.

4.   Verfahren nach den Ansprüchen 1 bis 3, **dadurch gekennzeichnet, dass** die Erkennungsvektorsequenz auf der Basis von einer zuvor gebildeten und gespeicherten Vektorsequenz, Prüfvektoren genannt, erzeugt wird, die so gestaltet ist, dass sie nur die Ermittlung des Vorhandenseins eines einzigen gestörten Ports in der gestörten Schaltung durch Messen des Wertes der Stromaufnahme im Ruhezustand IDDQ der gestörten Schaltung zulässt, und jeder Prüfvektor, für den das binäres Signal von wenigstens einem Eingangsanschluss dazu neigt, seinen Logikzustand zu ändern, in eine Mehrzahl von Erkennungsvektoren zerlegt wird, deren binäre Signale ihren Logikzustand nicht ändern.

5.   Verfahren nach einem der Ansprüche 1 bis 4, **dadurch gekennzeichnet, dass** die Erkennungsvektorsequenz so erzeugt wird, dass sich zwei aufeinander folgende Erkennungsvektoren durch den Wert eines einzigen binären Signals voneinander unterscheiden, das an einen einzigen Eingangsanschluss angelegt wird.

6.   Verfahren nach einem der Ansprüche 1 bis 5, **dadurch gekennzeichnet, dass** zum Messen des Wertes der Stromaufnahme im Ruhezustand IDDQ der gestörten Schaltung wenigstens ein Versorgungsanschluss der gestörten Schaltung am Eingang einer als Strom-Spannung-Wandler montierten Verstärkerschaltung (23) angeschlossen wird.

7.   Verfahren nach Anspruch 6, **dadurch gekennzeichnet, dass** der mit einem niedrigen Potential VSS verbundene Versorgungsanschluss der gestörten Schaltung verwendet wird, und dadurch, dass die montierte Verstärkerschaltung (23) ein Strom-Spannungs-Wandler ist, der so gestaltet ist, dass er eine virtuelle Masse erzeugt, die entsprechend den Beschränkungen einstellbar ist, die durch die Speisung der integrierten Schaltung auferlegt werden, auf der der Wert des Stroms IDDQ gemessen wird.

8.   Verfahren nach Anspruch 7, **dadurch gekennzeichnet, dass** ermittelt wird, ob der gemessene IDDQ(j)-Wert normal oder anormal ist, indem er mit einem bekannten Nennwert der Stromaufnahme im Ruhezustand IDDQnom der gestörten Schaltung verglichen wird.

9.   Verfahren nach einem der Ansprüche 1 bis 7, **dadurch gekennzeichnet, dass** ermittelt wird, ob der gemessene IDDQ(j)-Wert normal oder anormal ist, indem die folgende normalisierte Differenz errechnet wird:

$$D=[IDDQ(j)-IDDQ^0(j)]/maximum[IDDQ^0(j), Imin]$$

wobei
IDDQ(j) der gemessene Wert der Stromaufnahme im Ruhezustand IDDQ der gestörten Schaltung mit dem Prüfvektor j ist,
$IDDQ^0(j)$ der gemessene Wert der Stromaufnahme im Ruhezustand IDDQ einer Kalibrierschaltung ist,
Imin ein vorbestimmter Mindeststromwert zum Löschen von Rauscheffekten ist, wobei der IDDQ(j)-Wert als anormal angesehen wird, wenn D größer ist als ein vorbestimmter Schwellenwert DS.

10.  Verfahren nach Anspruch 9, **dadurch gekennzeichnet, dass** DS zwischen 2 und 100 gewählt wird.

11.  Verfahren nach einem der Ansprüche 1 bis 10, **dadurch gekennzeichnet, dass** nach der Durchführung eines ersten Vergleichs, bei dem wenigstens eine Störungszone der Oberfläche des Chips gewählt wurde, wenigstens ein späterer Vergleich nur auf der Basis von Vektorbildern durchgeführt wird, die der genannten Störungszone entsprechen.

12.  Verfahren nach einem der Ansprüche 1 bis 11, **dadurch gekennzeichnet, dass** für einen anormalen Erkennungsvektor ein Vergleich von zwei Bildersätzen der gestörten Schaltung und/oder einer Kalibrierschaltung durchgeführt wird, wobei wenigstens einer der beiden Bildersätze ein Satz von Vektorbildern ist, der mit dem genannten anormalen Erkennungsvektor erhalten wurde, um eine Störungszone zu wählen, in der sich der gestörte Logikport befinden kann, und danach ein späterer Vergleich nur mit den Vektorbildersätzen durchgeführt wird, die die genannte Störungszone repräsentieren.

13.  Verfahren nach den Ansprüchen 1 bis 12, **dadurch gekennzeichnet, dass** bei einem ersten Vergleich der Fehlererkennungsstufe als anormales Vektorbild wenigstens ein Vektorbild eines Vektorbildersatzes verwendet wird, das mit dem ersten anormalen Erkennungsvektor erhalten wurde, der als erster in der Sequenz von Erkennungsvektoren erscheint.

**14.** Verfahren nach den Ansprüchen 1 bis 13, **dadurch gekennzeichnet, dass** die elektrische Funktionalität der gestörten Schaltung geprüft wird, und wenn sich die gestörte Schaltung für wenigstens einen Ausgangsanschluss als nicht funktionell erweist, als Referenzbild ein Vektorbild verwendet wird, Fehlerreferenzbild (71) genannt, das mit der gestörten Schaltung für einen Erkennungsvektor erhalten wurde, normaler Erkennungsvektor genannt, für den der gemessene Wert der Stromaufnahme im Ruhezustand IDDQ der gestörten Schaltung normal ist.

**15.** Verfahren nach den Ansprüchen 13 und 14, **dadurch gekennzeichnet, dass** als Fehlerreferenzbild (71) ein Vektorbild verwendet wird, das mit der gestörten Schaltung erhalten wurde, wenn dieselbe Sequenz von Erkennungsvektoren mit einem Erkennungsvektor vor dem anormalen Erkennungsvektor erhalten wurde.

**16.** Verfahren nach den Ansprüchen 14 und 15, **dadurch gekennzeichnet, dass** für einen Vergleich als anormales Vektorbild ein Vektorbild verwendet wird, anormales Fehlervektorbild (70) der gestörten Schaltung genannt, und dadurch, dass zum Vergleichen des anormalen Fehlervektorbildes (70) mit dem Fehlerreferenzbild (71) ein Bild gebildet wird, einfaches Fehlereingangsbild (72, 72') genannt, das die äquipotentiellen Leitungen der gestörten Schaltung repräsentiert, die dieselbe Form, dieselbe Platzierung und unterschiedliche Potentialzustände zwischen dem anormalen Fehlervektorbild (70) und dem Fehlerreferenzbild (71) haben, so dass sie für die äquipotentielle Eingangsleitung des gestörten Logikports repräsentativ sind.

**17.** Verfahren nach Anspruch 16, **dadurch gekennzeichnet, dass** mehrere einfache Fehlereingangsbilder (72, 72') auf der Basis desselben anormalen Fehlervektorbildes (70) gebildet werden, die mit mehreren Fehlerreferenzbildern (71) verglichen werden, und dadurch, dass ein Bild gebildet wird, Verknüpfungsfehlereingangsbild (75) genannt, das die gemeinsamen äquipotentiellen Leitungen zwischen den verschiedenen einfachen Fehlereingangsbildern (72, 72') repräsentiert.

**18.** Verfahren nach einem der Ansprüche 14 bis 17, **dadurch gekennzeichnet, dass** in der Stufe der Erkennung des gestörten Ports wenigstens ein Vergleich zwischen zwei Bildern einer Kalibrierschaltung durchgeführt wird, die von einem anormalen Vektorbild gebildet sind, anormales Kalibriervektorbild genannt (76), das durch Anwenden eines anormalen Erkennungsvektors an diese Kalibrierschaltung erhalten wird, und eines Referenzbildes, Kalibrierreferenzbild (77) genannt, das durch Anwenden eines normalen Erkennungsvektors an die Kalibrierschaltung erhalten wird.

**19.** Verfahren nach Anspruch 18, **dadurch gekennzeichnet, dass** auf der Basis des anormalen Kalibriervektorbildes (76) und des Kalibrierreferenzbildes (77) ein Bild gebildet wird, einfaches Ein-/Ausgangskalibrierbild (78, 78') genannt, das die äquipotentiellen Leitungen der Kalibrierschaltung repräsentiert, die dieselbe Form, dieselbe Platzierung und unterschiedliche Potentialzustände zwischen dem anormalen Kalibriervektorbild (76) und dem Kalibrierreferenzbild (77) haben, so dass sie für die äquipotentielle Eingangsleitung und die äquipotentielle Ausgangsleitung des gestörten Logikports der gestörten Schaltung repräsentativ sind.

**20.** Verfahren nach Anspruch 19, **dadurch gekennzeichnet, dass** mehrere einfache Ein-/Ausgangskalibrierbilder (78, 78') auf der Basis desselben anormalen Kalibriervektorbildes (76) gebildet werden, die mit mehreren Kalibrierreferenzbildern (77) verglichen werden, und dadurch, dass ein Bild gebildet wird, Ein-/Ausgangs-Verknüpfungskalibrierbild (79) genannt, das die zwischen den unterschiedlichen einfachen Ein-/Ausgangskalibrierbildern (78, 78') gemeinsamen äquipotentiellen Leitungen repräsentiert.

**21.** Verfahren nach einem der Ansprüche 16 oder 17 sowie nach einem der Ansprüche 19 oder 20, **dadurch gekennzeichnet, dass** bei einem späteren Vergleich ein Bild gebildet wird, Ausgangsbild (80) genannt, das die äquipotentiellen Leitungen repräsentiert, die auf einem einfachen Fehlereingangsbild (72, 72') oder einer Verknüpfung (75) oder auf einem einfachen Ein/Ausgangskalibrierbild (78, 78') oder einer Verknüpfung (79) erscheinen; unter Ausschluss der zwischen diesen Bildern gemeinsamen äquipotentiellen Leitungen, wobei dieses Ausgangsbild (80) die äquipotentielle Ausgangsleitung des gestörten Logikports und seine Ausbreitung in der gestörten Schaltung repräsentiert.

**22.** Verfahren nach Anspruch 21, **dadurch gekennzeichnet, dass** ein einfaches Fehlereingangsbild (72, 72') oder eine Verknüpfung (75) und ein Ausgangsbild (80), das denselben Oberflächenabschnitt des Chips repräsentiert, in rechteckige aneinandergrenzende Fenster derselben festen vorbestimmten Abmessungen unterteilt werden, die kleiner sind als die dieser Bilder (72, 72', 75, 80), dass für jedes Fenster geprüft wird, ob jedes der beiden Bilder (72, 72', 75, 80) wenigstens eine äquipotentielle Leitung aufweist oder nicht, und dass das/die Fenster, das/die wenigstens eine äquipotentielle Leitung in jedem dieser beiden Bilder (72, 72', 75, 80) aufweist/aufweisen, gewählt und gespeichert wird/werden.

23. Verfahren nach einem der Ansprüche 1 bis 13, **dadurch gekennzeichnet, dass** die elektrische Funktionalität der gestörten Schaltung geprüft wird, und wenn sich die gestörte Schaltung für alle Ausgangsanschlüsse als funktionell erweist, ein Vergleich zwischen wenigstens einem ersten anormalen Vektorbild (81), das mit einem ersten anormalen Erkennungsvektor erhalten wurde, und wenigstens einem zweiten anormalen Vektorbild (82) durchgeführt wird, das mit derselben Schaltung sowie mit einem zweiten anormalen Erkennungsvektor erhalten wurde, der sich von dem ersten anormalen Erkennungsvektor unterscheidet, wobei der erste und der zweite anormale Erkennungsvektor zu derselben Erkennungsvektorsequenz gehören.

24. Verfahren nach Anspruch 23, **dadurch gekennzeichnet, dass** ein Bild gebildet wird, Fehlerausgangsbild (83) genannt, das die äquipotentielle(n) Leitung(en) repräsentiert, die unterschiedlichen anormalen Vektorbildern (81, 82) gemeinsam ist/sind, umfassend die äquipotentielle Ausgangsleitung (87) des gestörten Logikports.

25. Verfahren nach Anspruch 24, **dadurch gekennzeichnet, dass** bei einem späteren Vergleich ein Bild gebildet wird, Zwischenausgangsbild (85) genannt, das die äquipotentiellen Leitungen repräsentiert, die gemeinsam auf dem Fehlerausgangsbild (83) und auf wenigstens einem normalen Vektorbild (84) erscheinen, das mit einem normalen Erkennungsvektor erhalten wurde, unter Ausschluss der äquipotentiellen Leitungen, die diesem Fehlerausgangsbild (83) und diesem normalen Vektorbild (84) gemeinsam sind, wobei das genannte Zwischenausgangsbild (85) die äquipotentielle Ausgangsleitung (87) des gestörten Logikports enthält.

26. Verfahren nach Anspruch 24 und 25, **dadurch gekennzeichnet, dass** bei einem späteren Vergleich ein Bild gebildet wird, Ausgangsbild (86) genannt, das die äquipotentiellen Leitungen repräsentiert, die dem Fehlerausgangsbild (83) und dem Zwischenausgangsbild (85) gemeinsam sind, wobei das genannte Ausgangsbild (86) die äquipotentielle Ausgangsleitung des gestörten Logikports repräsentiert.

27. Verfahren nach einem der Ansprüche 1 bis 26, **dadurch gekennzeichnet, dass** die Prüfbilder durch elektronische Kontrastabtastungsmikroskopie des Potentials durch Erfassen der sekundären Elektronen hergestellt werden.

28. Verfahren nach einem der Ansprüche 1 bis 27, **dadurch gekennzeichnet, dass** die monochromen Vektorbilder in Pixelform gespeichert werden und jeder Vergleich zwischen Bildern auf numerischem Weg Pixel für Pixel durchgeführt wird.

29. Verfahren nach Anspruch 28, **dadurch gekennzeichnet, dass** vor dem Verwenden eines Bildes in einer Bildervergleichsstufe zuvor eine Integration dieses Bildes auf mehrere identische, diesem Bild entsprechende Klischees und eine Medianfilterung durchgeführt werden, indem auf jedes Pixel der Medianwert der Gesamtheit der Pixel angewendet wird, die dieses Pixel und die dieses umgebenden Pixel enthält, um die von Rauschen verursachten Spitzen zu unterdrücken.

30. Verfahren nach einem der Ansprüche 28 oder 29, **dadurch gekennzeichnet, dass** zum Bilden eines Bildes, das die äquipotentiellen Leitungen repräsentiert, die in derselben Form und derselben Platzierung und mit unterschiedlichen Potentialzuständen zwischen zwei Ausgangspixeln vorliegen, Pixel für Pixel eine Differenz der beiden Ausgangsbilder gemäß der folgenden Formel realisiert wird:

$$PC=(PA-PB)/2 + INT(E/2)$$

wobei PA der Kontrastniveauwert des Pixels des ersten Eingangsbildes, PB der Kontrastniveauwert des Pixels des zweiten Eingangsbildes, E der maximale Kontrastniveauwert der Bilder, PC der Kontrastniveauwert des Pixels des gebildeten Bildes und INT die gesamte Teilfunktion ist.

31. Verfahren nach einem der Ansprüche 28 bis 30, **dadurch gekennzeichnet, dass** zum Herstellen eines Bildes, das die äquipotentiellen Leitungen repräsentiert, die zwei Ausgangsbildern gemeinsam sind, Folgendes durchgeführt wird:

- eine adaptive Schwellwertermittlungsstufe auf den drei Kontrastniveaus weiß, schwarz, grau,
- Pixel für Pixel eine Erweiterungsverknüpfung AND+, bei der auf jedes Pixel des herzustellenden Bildes die folgenden Kontrastniveaus angewendet werden:

  . schwarz, wenn die beiden Pixel der Ausgangsbilder am Ausgang der adaptiven Schwellwertermittlungsstufe schwarz sind,
  . weiß, wenn die beiden Pixel der Ausgangsbilder am Ausgang der adaptiven Schwellwertermittlungsstufe weiß sind,
  . grau in allen anderen Fällen.

32. Verfahren nach einem der Ansprüche 28 bis 31, **dadurch gekennzeichnet, dass** zum Herstellen eines Bildes, das die äquipotentiellen Leitungen des einen oder des anderen Ausgangsbildes repräsentiert, unter Ausschluss der äquipotentiellen Leitungen, die diesen beiden Ausgangsbildern gemeinsam sind, Folgendes durchgeführt wird:

- eine adaptive Schwellwertermittlungsstufe auf den drei Kontrastniveaus weiß, schwarz, grau;
- Pixel für Pixel ein erweiterter Vergleich XOR+, bei dem auf jedes Pixel des herzustellenden Bildes die folgenden Kontrastniveaus angewendet werden:

  - grau, wenn die beiden Pixel der Ausgangsbilder dasselbe Kontrastniveau am Ausgang der adaptiven Schwellwertermittlungsstufe haben,
  - weiß, wenn die beiden Pixel der Ausgangsbilder am Ausgang der adaptiven Schwellwertermittlungsstufe weiß und grau, oder weiß und schwarz, oder grau und schwarz sind,
  - schwarz, wenn die beiden Pixel der Ausgangsbilder schwarz und grau, oder schwarz und weiß, oder grau und weiß sind.

33. Vorrichtung zum Erkennen eines kurzschlussartigen Fehlers eines Logikports, gestörter Logikport genannt, einer integrierten Schaltung, gestörte Schaltung genannt, umfassend einen Chip mit Eingangsanschlüssen und Ausgangsanschlüssen, die durch elektrische Leiterbahnen miteinander verbunden sind, und Logikports, die im Inneren des Chips der Schaltung in der allgemeinen Form eines Wafers ausgebildet sind, die eine Hauptebene des Chips definiert, wobei die Bahnen in der Dicke des Chips oder in der Oberfläche global parallel zur Hauptebene verlaufen, wobei die Ein- und Ausgangsanschlüsse auf der Peripherie des Chips mit den Bahnen verbunden sind und wenigstens zwei Gleichspannungsversorgungsanschlüsse (VDD-VSS), von denen wenigstens ein Versorgungsanschluss mit einem hohen Potential VDD und wenigstens ein Versorgungsanschluss mit einem niedrigen Potential VSS verbunden ist, wobei die genannte Vorrichtung Folgendes umfasst:

- Mittel (10) zum Erzeugen und Speichern einer Sequenz von unterschiedlichen Vektoren, Erkennungsvektoren genannt, die jeweils aus einem Satz von binären Signalen gebildet sind, die auf verschiedene Eingangsanschlüsse der gestörten Schaltung angewendet werden können und den Logikzustand 0 oder 1 haben können und diesen Logikzustand für die gesamte Dauer behalten, während der der Erkennungsvektor auf den Eingangsanschlüssen angewendet wird,

- äquipotentielle Bilderzeugungsmittel (1), die so gestaltet sind, dass sie für wenigstens einen Erkennungsvektor, der auf die Eingangsanschlüsse der gestörten Schaltung und einer integrierten Schaltung, Kalibrierschaltung genannt, die keinen gestörten Port und keinen Fehler hat und ansonsten mit der gestörten Schaltung identisch ist, einen Satz von Bildern, Vektorbilder genannt, erzeugen und speichern können, der äquipotentielle Leitungen repräsentiert, die von den Bahnen und den Logikports der genannten Schaltung gebildet werden, wobei jede äquipotentielle Leitung einem der auf den Vektorbildern differenzierten Potentialzustände entspricht,

wobei die verschiedenen Vektorbilder desselben Bildersatzes so gestaltet sind, dass sie die gesamte Oberfläche des Chips oder einen gesamten Abschnitt dieser Oberfläche bedecken, auf der der gestörte Logikport erkannt werden soll,

- Mittel (11, 12) zum schrittweisen Anwenden der Sequenz von Erkennungsvektoren auf die Eingangsanschlüsse der gestörten Schaltung,
- Mittel (23), um für jeden Erkennungsvektor den IDDQ(j)-Wert der Stromaufnahme im Ruhezustand IDDQ der gestörten Schaltung an einem der Versorgungsanschlüsse zu messen,
- Rechenmittel (11) zum Ermitteln, ob dieser gemessene IDDQ(j)-Wert normal oder anormal ist, und zum Speichern des Ergebnisses dieser Ermittlung,
- Rechenmittel (6) zum Durchführen von wenigstens einem Vergleich zwischen wenigstens einem anormalen Vektorbild (70, 76, 81, 89) und einem weiteren zuvor gespeicherten Bild, Referenzbild (71, 77, 82, 88) genannt, das einem selben Abschnitt der Oberfläche des Chips der gestörten Schaltung oder der Kalibrierschaltung entspricht wie das anormale Vektorbild, wobei diese Bilder so gewählt werden, dass dieser Vergleich ein Wählen einer Zone, Störungszone genannt, der Oberfläche des Chips zulässt, auf der sich eine äquipotentielle Eingangsleitung (73) des gestörten Logikports und/oder eine äquipotentielle Ausgangsleitung (74) des gestörten Logikports und/oder der gestörte Logikport befinden kann/können.

34. Vorrichtung nach Anspruch 33, **dadurch gekennzeichnet, dass** die Mittel (23) zum Messen des Wertes der Stromaufnahme im Ruhezustand IDDQ der Schaltung eine als Strom-Spannung-Wandler montierte Verstärkerschaltung (23) umfassen.

35. Vorrichtung nach Anspruch 34, **dadurch gekenn-**

**zeichnet, dass** die als Strom-Spannung-Wandler montierte Verstärkerschaltung (23) so gestaltet ist, dass sie eine virtuelle Masse erzeugt, die gemäß den durch die Versorgung der integrierten Schaltung auferlegten Beschränkungen justierbar ist.

**35**

# Fig 1

EP 1 129 407 B1

Fig 2

Fig 3

```
┌─────────────────────────┐
│            31           │
└─────────────────────────┘
            │
┌─────────────────────────┐
│            32           │
└─────────────────────────┘
            │
┌─────────────────────────┐
│            33           │
└─────────────────────────┘
            │
┌─────────────────────────┐
│            40           │
└─────────────────────────┘
            │
┌─────────────────────────┐
│            56           │
└─────────────────────────┘
            │
┌─────────────────────────┐
│            57           │
└─────────────────────────┘
            │
┌─────────────────────────┐
│            58           │
└─────────────────────────┘
            │
┌─────────────────────────┐
│            59           │
└─────────────────────────┘
```

Fig 4a

Val

Clock

IN_x

0    1

Fig 4b

Val

Clock

IN_x

0  1  2  3  4  5  6  7

Fig 4c

Val

Clock

IN_x

0 1 2  3  4  5  6  7  8

Fig 5

Fig 6

NRZ

DNRZ

RZ

R1

RC

0 | 1 | 0

Fig 7a

IDDQ.nom

IDDQ(j)

j

Fig 7b

IDDQ(j)

IDDQ̊(j)

DS

D

j

Fig 8

EP 1 129 407 B1

41

42

43

44

46 j=j+1

45

47

48

49

50

51

52

j=j+1

54

53

55

Fig 9

EP 1 129 407 B1

## Fig 10a

## Fig 10b

44

Fig 10c

Fig 11a

Fig 11b

Fig 12a

Fig 12b

88

89

AND+

92

91

Fig 13

P1

P3

P5

P2

P4

0

N

G

B

255

Fig 14